# EUROPEAN PATENT APPLICATION

(11) **EP 3 716 732 A1**
(43) Date of publication of application: **30.09.2020**
(21) Application number: 18878308.8
(22) Date of filing: 19.11.2018
(51) Int. Cl.: H05B 33/10, G02F 1/13357, G09F 9/30, H01L 27/32, H01L 51/50

(54) **METHOD FOR PRODUCING ORGANIC THIN FILM, ORGANIC THIN FILM, AND USE THEREOF**

(30) Priority: 20.11.2017 WO PCT/JP2017/041629
(71) Applicant: Hitachi Chemical Co., Ltd., Chiyoda-ku Tokyo 100-6606 (JP)
(72) Inventor: KAMO Kazuyuki, Tokyo 100-6606 (JP); KODAMA Shunsuke, Tokyo 100-6606 (JP); FUKUSHIMA Iori, Tokyo 100-6606 (JP); MORIYAMA Ryota, Tokyo 100-6606 (JP); SUGIOKA Tomotsugu, Tokyo 100-6606 (JP); HONNA Ryo, Tokyo 100-6606 (JP); ISHITSUKA Kenichi, Tokyo 100-6606 (JP)
(74) Representative: Beckmann, Claus
(86) International application number: PCT/JP2018/042595
(87) International publication number: WO 2019/098356

(57) **Abstract**

Provided is a production method related to an organic thin film formed using an organic electronic material containing a charge transport compound, the method suppressing any deterioration in performance during film formation and enabling the formation of an organic thin film having excellent performance. The method for producing an organic thin film includes a step of forming a coating film of an organic electronic material containing a charge transport compound, and a step of heating the coating film under an inert gas atmosphere to form an organic thin film.

## Description

### TECHNICAL FIELD

The present invention relates to an organic thin film and a method for producing the same. Further, the present invention relates to an organic electroluminescent element having the organic thin film, and a display element, an illumination device and a display device that use the organic electroluminescent element.

### BACKGROUND ART

Organic electronic elements are elements that use an organic substance to perform an electrical operation, and because it is anticipated that such organic electronic elements will be capable of providing advantages such as lower energy consumption, lower prices and greater flexibility, they are attracting much attention as a potential alternative technology to conventional inorganic semiconductors containing mainly silicon. Examples of organic electronic elements include organic electroluminescent elements (hereafter also referred to as "organic EL elements"), organic photoelectric conversion elements, and organic transistors.

Organic EL elements are attracting attention for potential use in large-surface area solid state lighting applications to replace incandescent lamps or gas-filled lamps. Further, organic EL elements are also attracting attention as the leading self-luminous display for replacing liquid crystal displays (LCD) in the field of flat panel displays (FPD), and commercial products are becoming increasingly available.

Depending on the organic electronic materials used, organic EL elements are broadly classified into two types: low-molecular weight type organic EL elements and polymer type organic EL elements. In polymer type organic EL elements, a polymer compound is used as the organic electronic material, whereas in low molecular weight type organic EL elements, a low-molecular weight compound is used. On the other hand, the production methods for organic EL elements are broadly classified into dry processes in which film formation is mainly performed in a vacuum system, and wet processes in which film formation is performed by plate-based printing such as relief printing or intaglio printing, or by plateless printing such as inkjet printing. Because wet processes enable simple film formation, they are expected to be an indispensable method in the production of future large-screen organic EL displays.

Accordingly, much development of materials suitable for wet processes is being pursued, and for example, investigations are being undertaken into the formation of multilayer structures using charge transport compounds having polymerizable functional groups (for example, see Patent Document 1 and Non-Patent Document 1).

### PRIOR ART DOCUMENTS

### PATENT DOCUMENT

Patent Document 1: JP 2006-279007 A

### NON-PATENT DOCUMENT

Non-Patent Document 1: Kengo Hirose, Daisuke Kumaki, Nobuaki Koike, Akira Kuriyama, Seiichiro Ikehata, and Shizuo Tokito, 53rd Meeting of the Japan Society of Applied Physics and Related Societies, 26p-ZK-4 (2006)

### SUMMARY OF THE INVENTION

### PROBLEMS TO BE SOLVED BY THE INVENTION

Organic EL elements produced using wet processes have the advantages of facilitating cost reductions and increases in the element surface area. However, conventional organic EL elements produced using wet processes have not necessarily exhibited entirely satisfactory element characteristics such as drive voltage, emission efficiency and emission lifespan, and further improvements would be desirable.

In a wet process, usually, a solution prepared by dissolving a charge transport compound in a solvent is applied to form a coating film, and the coating film is then heated to form an organic thin film. Accordingly, if the oxidation resistance of the charge transport compound used as the material for the organic thin film is unsatisfactory, then surface oxidation of the organic thin film tends to occur readily during heating.

Surface oxidation of the organic thin film causes a deterioration in the inherent performance of the organic thin film and can cause a deterioration in the element characteristics such as an increase in drive voltage, and is therefore undesirable. Charge transport compounds having polymerizable functional groups are materials that are suited to wet processes, but from the viewpoint of oxidation resistance and the like, further improvements would be desirable. On the other hand, in order to improve element characteristics, in addition to the development of organic thin film materials, methods for suppressing any deterioration in the performance of the organic thin films are also important. Accordingly, in the production of organic thin films using wet processes, a production method that is able to suppress any deterioration in the performance of the organic thin film during film formation, enabling the formation of an organic thin film having superior performance, would be very desirable.

The present invention has been develop in light of the above circumstances, and has an object of providing a production method that is able to suppress any deterioration in the performance of the organic thin film during film formation by a wet process, enabling the formation of an organic thin film having superior performance. Further, the present invention also has the objects of providing an organic EL element having an organic thin film obtained using the production method, and a display element, an illumination device and a display device that use the organic EL element.

### MEANS TO SOLVE THE PROBLEMS

As a result of intensive investigation of methods for producing organic thin films using wet processes, the inventors of the present invention discovered that the atmosphere for the heating process during film formation had a large effect on the performance of the organic thin film, enabling them to complete the present invention.

In other words, the present invention relates to the embodiments described below. However, the present invention is not limited to the following embodiments.

One embodiment relates to a method for producing an organic thin film, wherein the method includes a step of forming a coating film by applying an organic electronic material containing a charge transport compound, and a step of heating the coating film under an inert gas atmosphere to form an organic thin film.

In the production method of the above embodiment, the organic electronic material preferably also contains a solvent.

The above charge transport compound preferably has hole injection properties or hole transport properties.

The charge transport compound preferably contains at least one structure selected from the group consisting of aromatic amine structures, pyrrole structures, carbazole structures, thiophene structures, benzene structures, aniline structures, phenoxazine structures and fluorene structures.

The charge transport compound preferably has a structure that is branched in three or more directions.

The charge transport compound preferably has at least one polymerizable functional group.

The polymerizable functional group is preferably at least one group selected from the group consisting of an oxetane group, epoxy group, vinyl group, acryloyl group, and methacryloyl group.

The organic electronic material preferably also contains a polymerization initiator.

The polymerization initiator is preferably an ionic compound. The ionic compound is preferably an onium salt.

Another embodiment relates to an organic thin film produced using the method for producing an organic thin film according to the embodiment described above.

Another embodiment relates to a laminate having an organic thin film formed from an organic electronic material containing a charge transport compound, and an upper layer provided on top of the organic thin film, wherein the dispersion in the oxygen atom distribution through the depth direction including the interface between the organic thin film and the upper layer, calculated by irradiating a gas cluster ion beam onto the laminate from the side of the upper layer and measuring the oxygen ion intensity through the depth direction with a time-of-flight secondary ion mass spectrometer, is not more than 8.0%.

Another embodiment relates to an organic electroluminescent element having the organic thin film of the embodiment described above or the laminate of the embodiment described above. The organic electroluminescent element preferably also has a flexible substrate. Further, the organic electroluminescent element preferably also has a resin film substrate.

Another embodiment relates to a display element containing the organic electroluminescent element of the embodiment described above.

Another embodiment relates to an illumination device containing the organic electroluminescent element of the embodiment described above.

Another embodiment relates to a display device containing the illumination device of the embodiment described above and a liquid crystal element as a display unit.

Another embodiment relates to a method for producing an organic electroluminescent element having at least an organic thin film and a light-emitting layer disposed in that order between an anode and a cathode, with the organic thin film disposed adjacent to the anode, wherein the method has a step of forming the organic thin film on the anode using the method for producing an organic thin film according to the embodiment described above, a step of forming the light-emitting layer, and a step of forming the cathode.

### EFFECTS OF THE INVENTION

The present invention is able to provide a production method for an organic thin film having superior performance which is able to suppress any deterioration in performance during film formation. Further, the present invention can also provide an organic EL element that uses an organic thin film obtained using the production method and exhibits excellent element characteristics such as drive voltage, and a display element, an illumination device and a display device that use the organic EL element.

### BRIEF DESCRIPTION OF THE DRAWINGS

FIG. 1 is a cross-sectional schematic view illustrating one example of an organic EL element that represents an embodiment of the present invention.
FIG. 2 is a profile of an oxygen atom distribution measured through the depth direction by time-of-flight secondary ion mass spectrometry using a gas cluster ion beam (GCIB-TOF-SIMS), wherein (a) represents the measurement results for Example 9 and (b) represents the measurement results for Comparative Example 9.

### EMBODIMENTS FOR CARRYING OUT THE INVENTION

Embodiments of the present invention are described below in detail, but the present invention is not limited to the following embodiments.

### <Method for Producing Organic Thin Film>

In one embodiment, a method for producing an organic thin film includes a step of forming a coating film of an organic electronic material containing a charge transport compound, and a step of heating the coating film under an inert gas atmosphere to form an organic thin film.

Formation of the coating film is conducted under an open atmosphere, or an inert gas atmosphere, by applying the organic electronic material described above. Formation of the coating film is preferably conducted at room temperature. Here, room temperature means any temperature within a range from 10°C to 40°C, and preferably a temperature within a range from 20°C to 30°C. The organic electronic material is preferably used in the form of a coating solution (ink composition) obtained by dissolving the material in a solvent. Examples of the coating method include conventional methods, including spin coating methods; casting methods; dipping methods; plate-based printing methods such as relief printing, intaglio printing, offset printing, lithographic printing, relief reversal offset printing, screen printing and gravure printing; and plateless printing methods such as inkjet methods.

Formation of the organic thin film is conducted by heating the coating film under an inert gas atmosphere. By heating the coating film, the coating film solidifies to yield an organic thin film. In one embodiment, the organic thin film is a dried film formed by evaporation of the solvent within the coating film. In another embodiment, in those cases where the charge transport compound has a polymerizable functional group, the organic thin film is a cured film formed by heating, and if necessary irradiation with light, to cause a polymerization reaction of the charge transport compound. From the viewpoint of enabling multilayering using wet processes, the organic thin film is preferably a cured film. By performing the heating under an inert gas atmosphere following the coating film formation in accordance with the production method of the present invention, an organic thin film having superior performance can be obtained.

There are no particular limitations on the thickness of the coating film and the organic thin film, and the thickness may be adjusted with due consideration of the application for the organic thin film. In one embodiment, the thickness may be within a range from 0.1 nm to 300 nm. When the film thickness is at least 0.1 nm, the efficiency of the charge transport can be more easily improved. On the other hand, when the film thickness is not more than 300 nm, the electrical resistance can be more easily reduced. The thickness is more preferably within a range from 1 nm to 200 nm, and even more preferably within a range from 3 to 100 nm.

In this description, examples of the "inert gas atmosphere" include rare gases such as helium gas or argon gas, nitrogen gas, or a mixed gas of these gases. The expression "under an inert gas atmosphere" means that the concentration of inert gas in the process atmosphere, expressed as a volumetric ratio, is at least 99.5%, and preferably 99.9% or higher. In the production method described above, in terms of cost and convenience, the heating of the coating film is preferably conducted under a nitrogen gas atmosphere.

"Heating of the coating film" means applying heat to the coating film to raise the temperature of the coating film. Although there are no particular limitations on the heating, from the viewpoint of enabling efficient removal of the solvent, the heating is preferably conducted at a temperature at least as high as the boiling point of the solvent used in the ink composition. Further, in those cases where the charge transport compound has a polymerizable functional group, a temperature at which the polymerization reaction proceeds favorably is preferred. In one embodiment, the heating temperature for the coating film is preferably at least 140°C, more preferably at least 170°C, and even more preferably 180°C or higher. On the other hand, from the viewpoint of suppressing any deterioration in the performance of the organic thin film caused by thermal degradation or the like, the heating temperature is preferably not more than 300°C, more preferably not more than 280°C, and even more preferably 250°C or lower. Here, deterioration in the performance of the organic thin film means a reduction in the carrier density and the charge mobility and the like caused by thermal degradation or surface oxidation or the like. By employing the production method of the embodiment described above, any deterioration in the performance of the organic thin film is suppressed, and an organic thin film having superior performance can be obtained with ease. Using this type of organic thin film facilitates improvement in the drive voltage, emission efficiency and emission lifespan of the element.

There are no particular limitations on the heating time, but from the viewpoint of improving productivity, the heating time is preferably not longer than two hours, more preferably not longer than one hour, and even more preferably 30 minutes or less. Further, from the viewpoint of ensuring reliable removal of the solvent and progression of the polymerization reaction, the heating time is preferably at least one minute, more preferably at least 3 minutes, and even more preferably 5 minutes or longer.

The heating of the coating film can be conducted, for example, using a hot plate or an oven. The heating under an inert gas atmosphere can be achieved by using a hot plate under an inert gas atmosphere or by replacing the air inside an oven with an inert gas atmosphere.

In one embodiment, the heating of the coating film is preferably performed under conditions including a nitrogen gas atmosphere, a temperature within a range from 180 to 250°C, more preferably a temperature from 190 to 240°C, and even more preferably a temperature from 200 to 230°C, for a heating time of 5 to 60 minutes. Even at the same heating temperature, if the heating time is lengthened, then the performance of the organic thin film is more likely to deteriorate. Accordingly, the heating time is more preferably 30 minutes or less.

The heating of the coating film is preferably conducted, for example, by bringing the substrate on which the coating film has been formed into contact with the surface of a hot plate that has been installed in an inert gas atmosphere and heated to a temperature within a range from 180 to 250°C, for a period of 5 to 60 minutes. The heating time (contact with the hot plate surface) is more preferably 30 minutes or less.

There are no particular limitations on the organic electronic material used in the method for producing an organic thin film described above. From the viewpoint of further enhancing the suppression effect on any deterioration in the performance of the organic thin film, the use of an organic electronic material containing a charge transport compound having excellent heat resistance and oxidation resistance and the like is preferred. Organic electronic materials that may be used in the method for producing an organic thin film described above are described below in further detail.

### (Organic Electronic Material)

In one embodiment, from the viewpoint of facilitating multilayering of organic thin films using wet processes, the organic electronic material used for forming the organic thin film preferably contains a charge transport compound having a polymerizable functional group within the molecule. In one embodiment, even if the organic electronic material contains two or more types of charge transport compounds having a polymerizable functional group, the organic electronic material may also contain one or more other charge transport compounds.

### [Charge Transport Compound]

In one embodiment, the charge transport compound has one or more structural units having charge transport properties, and at least one of those structural units has a structural region represented by the formula shown below.

-Ar-(L)ₐ-Z

In the above formula, Ar represents an arylene group or a heteroarylene group, L represents a linking group, a is 0 or 1, and Z represents a substituted or unsubstituted polymerizable functional group. In the formula, the linking group L represents a divalent linking group, but there are no other particular limitations.

In one embodiment, the charge transport compound has one or more structural units having charge transport properties, and at least one of those structural units preferably has a structural region represented by formula (I) shown below.

-Ar-X-Y-Z (I)

In the formula, Ar represents an arylene group or a heteroarylene group, X represents a linking group described below, Y represents an aliphatic hydrocarbon group of 1 to 10 carbon atoms, and Z represents a substituted or unsubstituted polymerizable functional group.

In each of the formulas, Ar represents an arylene group or a heteroarylene group. An arylene group means an atom grouping in which two hydrogen atoms have been removed from an aromatic hydrocarbon. Specific examples of the aromatic hydrocarbon include benzene, naphthalene, anthracene, tetracene, fluorene and phenanthrene. The arylene group preferably has 6 to 30 carbon atoms.

A heteroarylene group means an atom grouping in which two hydrogen atoms have been removed from an aromatic heterocycle. Specific examples of the aromatic heterocycle include pyridine, pyrazine, quinoline, isoquinoline, acridine, phenanthroline, furan, pyrrole, thiophene, carbazole, oxazole, oxadiazole, thiadiazole, triazole, benzoxazole, benzoxadiazole, benzothiadiazole, benzotriazole and benzothiophene. The heteroarylene group preferably has 2 to 30 carbon atoms.

Ar may have a single ring structure such as benzene, or may have a condensed ring structure having rings condensed together such as naphthalene. Further, Ar may have a structure in which two or more independent structures selected from among single ring structures and condensed ring structures are bonded together. Examples of this type of structure include biphenyl, terphenyl and triphenylbenzene. Ar may be either unsubstituted, or have one or more substituents. In those cases where Ar has a substituent, the substituent may, for example, be a linear, cyclic or branched alkyl group of 1 to 22 carbon atoms.

In one embodiment, Ar is preferably a phenylene group or a naphthylene group, and is more preferably a phenylene group.

In the above formula (I), X is any linking group selected from the group consisting of formulas (x1) to (x10) shown below.

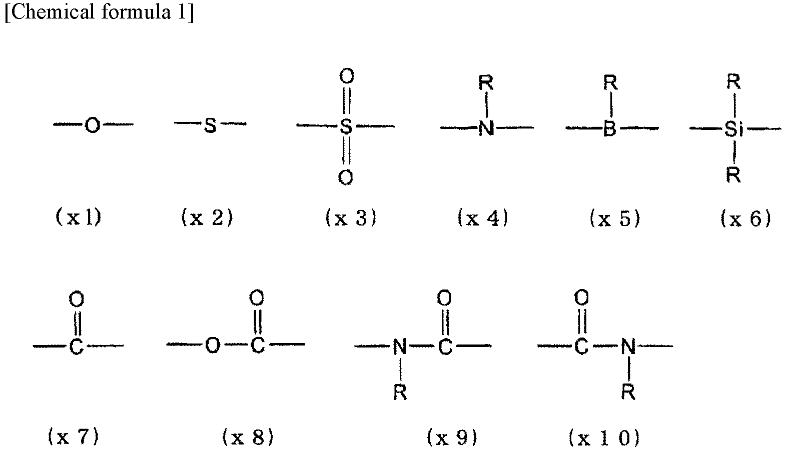

In the formulas, each R independently represents a hydrogen atom, a linear, cyclic or branched alkyl group of 1 to 22 carbon atoms, an aryl group of 6 to 30 carbon atoms, or a heteroarylgroup of 2 to 30 carbon atoms. In one embodiment, R is preferably a linear, cyclic or branched alkyl group of 1 to 22 carbon atoms. The number of carbon atoms is more preferably from 2 to 16, even more preferably from 3 to 12, and particularly preferably from 4 to 8. In another embodiment, R is preferably an aryl group of 6 to 30 carbon atoms, is more preferably a phenyl group or naphthyl group, and is even more preferably a phenyl group.

In one embodiment, the above linking group X is preferably x1. In other words, the charge transport compound preferably has a structural region represented by formula (II) below.

-Ar-O-Y-Z (1-1)

In formula (I), Y represents a divalent aliphatic hydrocarbon group of 1 to 10 carbon atoms. The aliphatic hydrocarbon group may be linear, branched or cyclic, or may have a combination of these structures. The aliphatic hydrocarbon group may be saturated or unsaturated.

In one embodiment, from the viewpoint of the ease of availability of themonomer that represents the raw material, Y is preferably a linear aliphatic hydrocarbon group, and is more preferably saturated. From these viewpoints, Y in formula (I) is preferably-(CH₂)ₙ-. In other words, in one embodiment, the charge transport compound preferably has a structural region represented by formula (I-2) below.

-Ar-X-(CH₂)ₙ-Z (1-2)

In the above formula, n is an integer from 1 to 10, preferably from 1 to 8, and more preferably from 1 to 6. From the viewpoint of the heat resistance, n is even more preferably from 1 to 4, and n is most preferably either 1 or 2.

As mentioned above, the charge transport compound preferably has a structural region represented by one of the above formulas (1-1) or (1-2), and more preferably has a structural region represented by formula (1-3) shown below.

-Ar-O-(CH₂)ₙ-Z (1-3)

In the above formula, n is an integer from 1 to 10, preferably from 1 to 8, and more preferably from 1 to 6. From the viewpoint of the heat resistance, n is even more preferably from 1 to 4, and n is most preferably either 1 or 2.

In each of the above formulas, Z represents a polymerizable functional group. A "polymerizable functional group" refers to a functional group which is able to form a bond upon the application of heat and/or light. The polymerizable functional group Z may be unsubstituted or substituted. Specific examples of the polymerizable functional group Z include groups having a carbon-carbon multiple bond (such as a vinyl group, allyl group, butenyl group, ethynyl group, acryloyl group and methacryloyl group), groups having a small ring (including cyclic alkyl groups such as a cyclopropyl group and cyclobutyl group; cyclic ether groups such as an epoxy group (oxiranyl group) and oxetane group (oxetanyl group); diketene groups; episulfide groups; lactone groups; and lactam groups), and heterocyclic groups (such as a furanyl group, pyrrolyl group, thiophenyl group and silolyl group).

A vinyl group, acryloyl group, methacryloyl group, epoxy group or oxetane group is particularly preferred as the polymerizable functional group Z. From the viewpoints of the reactivity and the characteristics of the organic electronic element, a vinyl group, oxetane group or epoxy group is even more preferred. These polymerizable functional groups may have a substituent. The substituent is preferably a linear, cyclic or branched alkyl group of 1 to 22 carbon atoms. This number of carbon atoms is more preferably from 1 to 8, and even more preferably from 1 to 4. The substituent is most preferably a linear alkyl group of 1 to 4 carbon atoms.

In one embodiment, from the viewpoint of the storage stability, the polymerizable functional group Z is preferably an oxetane group represented by formula (z1) shown below. In the formula, R preferably represents a hydrogen atom or an alkyl group of 1 to 4 carbon atoms. It is particularly preferable that R represents a methyl group or an ethyl group.

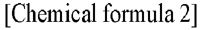

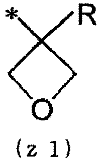

The charge transport compound having at least one structural region represented by formula (I) contains at least one polymerizable functional group Z within the structure. Compounds containing a polymerizable functional group can be cured by a polymerizaton reaction, and as a result of the curing, the solubility in solvents can be changed. Accordingly, the charge transport compound having at least one structural region represented by formula (I) is a material that exhibits excellent curability and is suited to wet processes.

In one embodiment, the charge transport compound may be any compound that has a structural region represented by the above formula (I) and has the ability to transport an electric charge. In one embodiment, the transported charge is preferably a positive hole. If the compound has hole transport properties, then the compound can be used, for example, as the material for a hole injection layer or a hole transport layer in an organic EL element. Further, in the case of an electon transport compound, the compound can be used as the material for an electron transport layer or an electron injection layer. Furthermore, if the compound is able to transport both holes and electrons, then the compound can be used as the material of a light-emitting layer or the like.

In one embodiment, the charge transport compound is preferably used as the material for a hole injection layer and/or hole transport layer, and is more preferably used as a hole injection layer material. Accordingly, the charge transport compound preferably has hole injection properties or hole transport properties, and more preferably has hole injection properties.

The charge transport compound has one, or two or more, structural units having charge transport properties, and at least one of the structural units has a structural region represented by the above formula (I). Charge transport materials can be broadly classified into low-molecular weight compounds composed of a single structural unit, and polymer compounds composed of a plurality of structural units, and the charge transport compound may be either type of compound.

Cases where the charge transport compound is a low-molecular weight compound are preferred in terms of enabling a high-purity material to be more easily obtained. Cases where the charge transport compound is a polymer compound are preferred in terms of enablng easier preparation of compositions, and exhibiting superior film formability. Moreover, from the viewpoints of obtaining the advantages of both types of compounds, a mixture of a low-molecular weight compound and a polymer compound may also be used as the charge transport compound. Polymer compounds composed of a plurality of structural units having charge transport properties are describe below in further detail as examples of the charge transport compound.

### [Charge Transport Polymers]

In those cases where the charge transport compound is a polymer compound, the charge transport compound may be a polymer or an oligomer. Hereafter, these two types of compound are jointly referred to as a "charge transport polymer". The charge transport polymer preferably has at least one structural region represented by formula (I) described above and shown below within the molecular structure.

-Ar-X-Y-Z (I)

If a polymerizable functional group exists at a terminal portion of the charge transport polymer with a linking group containing a structure represented by -Ar-CH₂-O- interposed therebetween, then when the charge transport polymer is used in combination with a polymerization initiator, intramolecular bond cleavage tends to occur readily upon heating, leading to the production of decomposition products. In contrast, in the case of a charge transport polymer having a structural region represented by formula (I), even when the polymer is used in combination with a polymerization initiator, decomposition products are unlikely to be produced upon heating. For these types of reasons, in the method for producing an organic thin film according to the embodiment described above, by using an organic electronic material containing a charge transport polymer having at least one structural region represented by the above formula (I), an organic thin film having superior performance can be more easily obtained.

The charge transport polymer may be linear, or may have a branched structure. The charge transport polymer preferably contains at least a divalent structural unit L having charge transport properties and a monovalent structural unit T that forms the terminal portions, and may also contain a trivalent or higher structural unit B that forms a branched portion. The charge transport polymer may have only one type of each of these structural units, or may contain a plurality of types of each structural unit. In the charge transport polymer, the various structural units are bonded together at "monovalent" to "trivalent or higher" bonding sites.

### (Structure of Charge Transport Polymer)

Examples of partial structures contained in the charge transport polymer are described below. However, the charge transport polymer is not limited to polymers having the following partial structures. In the partial structures, "L" represents a structural unit L, "T" represents a structural unit T, and "B" represents a structural unit B. The symbol "*" denotes a bonding site with another structural unit. In the following partial structures, the plurality of L units may be units having the same structure or units having mutually different structures. This also applies for the T and B units.

### Linear Charge Transport Polymers

[Chemical formula 3] T-L-L-L-L-L-*

### Charge Transport Polymers having Branched Structures

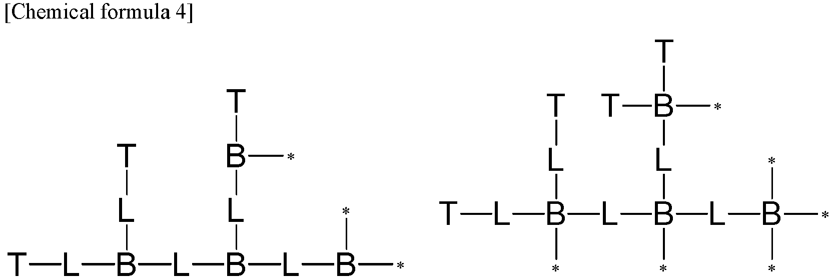

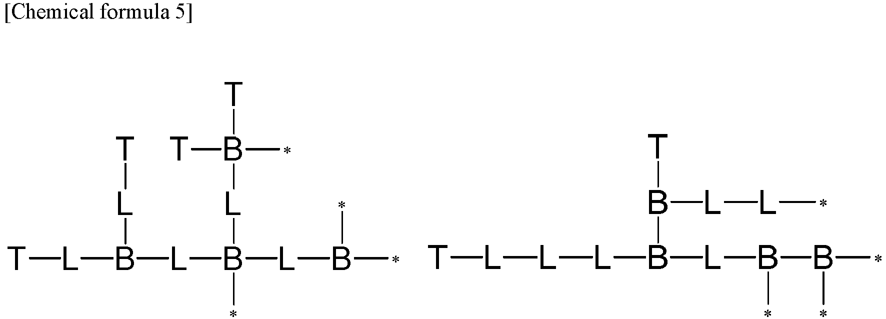

In one embodiment, the charge transport polymer preferably has a divalent structural unit L with charge transport properties. Further, in one embodiment, the charge transport polymer preferably has a structure that branches in three or more directions, namely a polymer having a structural unit B described above. The charge transport polymer preferably contains one or more structures selected from the group consisting of aromatic amine structures, carbazole structures, thiophene structures, bithiophene structures, benzene structures, phenoxazine structures and fluorene structures. These structures are preferably included in a structural unit L described below, but may be included in a structural unit B, or may be included in both a structural unit L and a structural unit B. By including one of these structures in the charge transport polymer, the charge transport properties, and particularly the hole transport properties, can be improved.

In one embodiment, the charge transport polymer may contain the structural region represented by formula (I) in at least one of the structural units L, B and T that constitute the polymer, and there are no particular limitations on the location in which the structural region is introduced. In one preferred embodiment, from the viewpoint of enhancing the curability, the structural region represented by formula (I) preferably exists in a structural unit T that constitutes at least one terminal portion of the charge transport polymer. Having the structural region represented by formula (I) exist in a structural unit T that constitutes a terminal portion is also preferred from the viewpoint of facilitating synthesis of the monomer compound used in forming the charge transport polymer. The structural units of the charge transport polymer are described below in further detail.

### (Structural Unit L)

The structural unit L is a divalent structural unit having charge transport properties. There are no particular limitations on the structural unit L, provided it includes an atom grouping having the ability to transport an electric charge. For example, the structural unit L may be selected from among substituted or unsubstituted structures including aromatic amine structures, carbazole structures, thiophene structures, fluorene structures, benzene structures, biphenyl structures, terphenyl structures, naphthalene structures, anthracene structures, tetracene structures, phenanthrene structures, dihydrophenanthrene structures, pyridine structures, pyrazine structures, quinoline structures, isoquinoline structures, quinoxaline structures, acridine structures, diazaphenanthrene structures, furan structures, pyrrole structures, oxazole structures, oxadiazole structures, thiazole structures, thiadiazole structures, triazole structures, benzothiophene structures, benzoxazole structures, benzoxadiazole structures, benzothiazole structures, benzothiadiazole structures, benzotriazole structures, and structures containing one, or two or more, of the above structures. The aromatic amine structures are preferably triarylamine structures, and more preferably triphenylamine structures.

In one embodiment, from the viewpoint of obtaining superior hole transport properties, the structural unit L is preferably selected from among substituted or unsubstituted structures including aromatic amine structures, carbazole structures, thiophene structures, fluorene structures, benzene structures, pyrrole structures, and structures containing one, or two or more, of these structures, and is more preferably selected from among substituted or unsubstituted structures including aromatic amine structures, carbazole structures, and structures containing one, or two or more, of these structures. In another embodiment, from the viewpoint of obtaining superior electron transport properties, the structural unit L is preferably selected from among substituted or unsubstituted structures including fluorene structures, benzene structures, phenanthrene structures, pyridine structures, quinoline structures, and structures containing one, or two or more, of these structures.

Specific examples of the structural unit L are shown below. However, the structural unit L is not limited to the following structures.

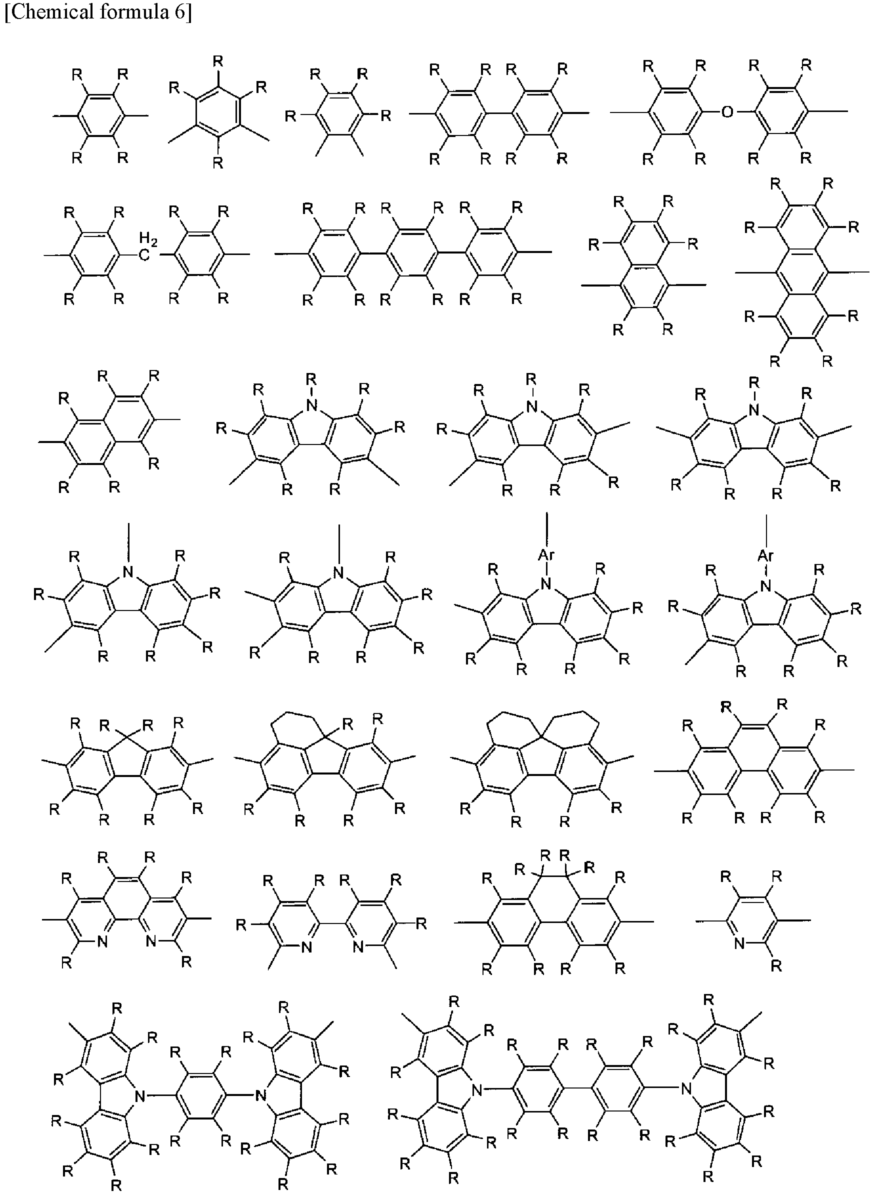

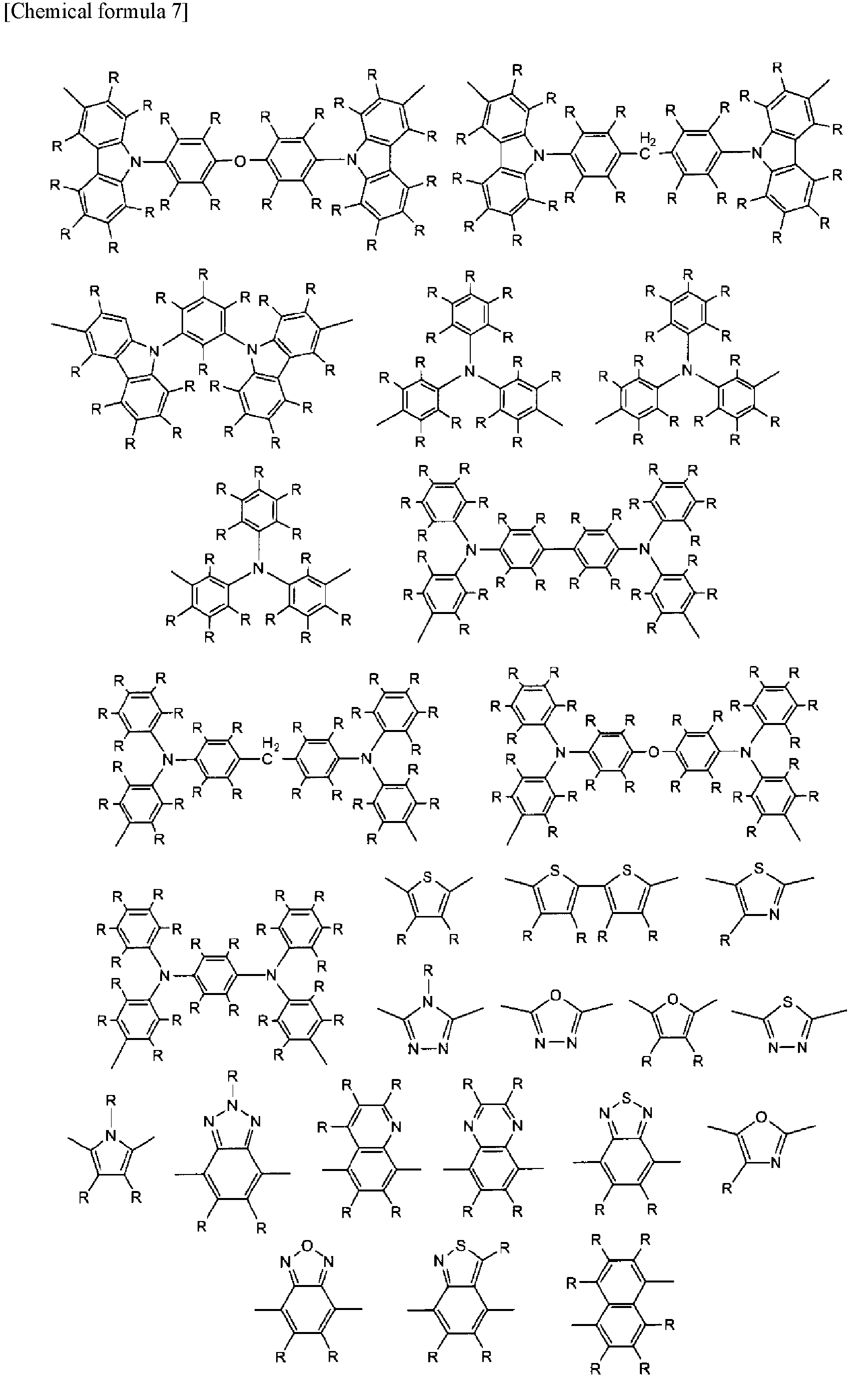

Each R independently represents a hydrogen atom or a substituent. It is preferable that each R is independently selected from a group consisting of -R¹, -OR², -SR³, -OCOR⁴, -COOR⁵, -SiR⁶R⁷R⁸, halogen atoms, and groups containing a polymerizable functional group described below. Each of R¹ to R⁸ independently represents a hydrogen atom, a linear, cyclic or branched alkyl group of 1 to 22 carbon atoms, an aryl group of 6 to 30 carbon atoms, or a heteroaryl group of 2 to 30 carbon atoms An aryl group is an atom grouping in which one hydrogen atom has been removed from an aromatic hydrocarbon. A heteroaryl group is an atom grouping in which one hydrogen atom has been removed from an aromatic heterocycle. The alkyl group may be further substituted with an aryl group or heteroaryl group of 2 to 20 carbon atoms, and the aryl group or heteroaryl group may be further substituted with a linear, cyclic or branched alkyl group of 1 to 22 carbon atoms.

In one embodiment, each R preferably independently represents a hydrogen atom, or a substituent selected from the group consisting of alkyl groups, aryl groups, alkyl-substituted aryl groups and halogen atoms. The halogen atom may be a chlorine atom, a fluorine atom, or a bromine atom or the like, and is preferably a fluorine atom.

Ar represents an arylene group of 6 to 30 carbon atoms or a heteroarylene group of 2 to 30 carbon atoms. An arylene group is an atom grouping in which two hydrogen atoms have been removed from an aromatic hydrocarbon. A heteroarylene group is an atom grouping in which two hydrogen atoms have been removed from an aromatic heterocycle. Ar is preferably an arylene group, and is more preferably a phenylene group.

Examples of the aromatic hydrocarbon include monocyclic hydrocarbons, condensed ring hydrocarbons, and polycyclic hydrocarbons in which two or more hydrocarbons selected from among monocyclic hydrocarbons and condensed ring hydrocarbons are bonded together viasingle bonds. Examples of the aromatic heterocycles include monocyclic heterocycles, condensed ring heterocycles, and polycyclic heterocycles in which two or more heterocycles selected from among monocyclic heterocycles and condensed ring heterocycles are bonded together via single bonds.

In one embodiment, the structural unit L preferably includes a structural unit L1 represented by a formula shown below.

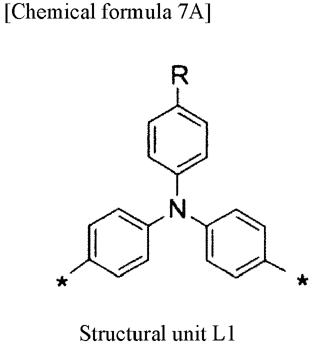

In the formula, R is the same as R described above. In this embodiment, R is preferably a linear alkyl group of 1 to 22 carbon atoms or a halogen atom. The linear alkyl group is more preferably a group of 2 to 16 carbon atoms, even more preferably a group of 3 to 12 carbon atoms, and particularly preferably a group of 4 to 8 carbon atoms. The halogen atom may be a chlorine atom, a fluorine atom, or a bromine atom or the like, and is preferably a fluorine atom. Among the various structural units LI, the structure in which R represents a fluorine atom is particularly preferred, as it tends to enable any deterioration in the performance of the organic thin film to be more easily suppressed during film formation.

### (Structural Unit B)

The structural unit B is a trivalent or higher structural unit that constitutes a branched portion in those cases where the charge transport polymer has a branched structure. From the viewpoint of improving the durability of the organic electronic element, the structural unit B is preferably not higher than hexavalent, and is more preferably either trivalent or tetravalent. The structural unit B is preferably a unit that has charge transport properties. For example, from the viewpoint of improving the durability of the organic electronic element, the structural unit B is preferably selected from among substituted or unsubstituted structures including aromatic amine structures, carbazole structures, condensed polycyclic aromatic hydrocarbon structures, and structures containing one, or two or more, of these structures.

Specific examples of the structural unit B are shown below. However, the structural unit B is not limited to the following structures.

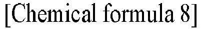

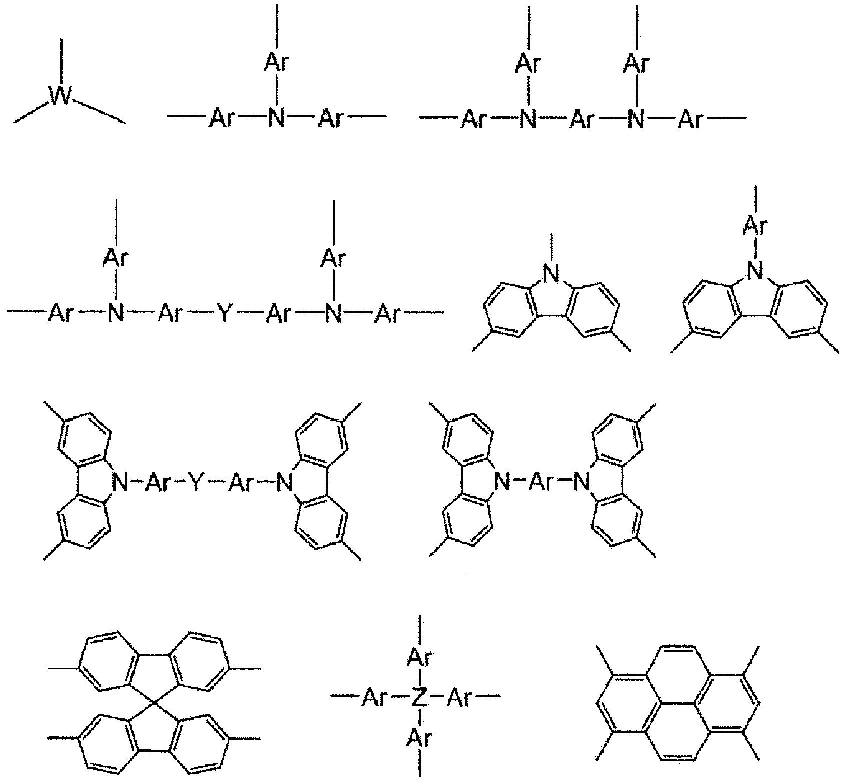

W represents a trivalent linking group, and for example, represents an arenetriyl group of 6 to 30 carbon atoms or a heteroarenetriyl group of 2 to 30 carbon atoms. An arenetriyl group is an atom grouping in which three hydrogen atoms have been removed from an aromatic hydrocarbon. A heteroarenetriyl group is an atom grouping in which three hydrogen atoms have been removed from an aromatic heterocycle. Each Ar independently represents a divalent linking group, and for example, may independently represent an arylene group of 6 to 30 carbon atoms or a heteroarylene group of 2 to 30 carbon atoms. Ar preferably represents an arylene group, and more preferably a phenylene group. Y represents a divalent linking group, and examples include divalent groups in which an additional hydrogen atom has been removed from any of the R groups having one or more hydrogen atoms (but excluding groups containing a polymerizable functional group) described in relation to the structural unit L. Z represents a carbon atom, a silicon atom or a phosphorus atom. In the structural units, the benzene rings and Ar groups may have a substituent, and examples of the substituent include the R groups in the structural unit L described above.

In one embodiment, the structural unit B preferably includes a structural unit B1 represented by a formula shown below.

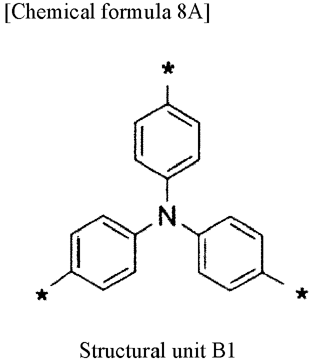

### (Structural Unit T)

The structural unit T is a monovalent structural unit that constitutes a terminal portion of the charge transport polymer. From the viewpoint of enhancing the curability, the charge transport polymer preferably has a polymerizable functional group at a terminal portion. In other words, the structural unit T preferably has a structure that contains a polymerizable functional group. In the following description, a structural unit T containing a polymerizable functional group is referred to as a structural unit T1. In one embodiment, the structural unit T1 has a structure represented by the formula shown below.

-Ar-(L)ₐ-Z

In the above formula, Ar represents an arylene group or a heteroarylene group, L represents a linking group, a is 0 or 1, and Z represents a substituted or unsubstituted polymerizable functional group. In the formula, the linking group L represents a divalentorganic group, but there are no other particular limitations.

In another embodiment, the structural unit T1 may have a structure which itself functions as a polymerizable functional group, such as a pyrrolyl group.

In one embodiment, the structural unit T1 preferably has a structure represented by formula (I) shown below.

-Ar-X-Y-Z (I)

In the formula, Ar represents an arylene group or a heteroarylene group, X represents a linking group, Y represents an aliphatic hydrocarbon group of 1 to 10 carbon atoms, and Z represents a substituted or unsubstituted polymerizable functional group.

In each formula, Ar, X, Y and Z are as described above in relation to the structural region represented by formula (I).

By using a charge transport polymer containing the structural unit T1 described above,excellent curability can be more easily obtained during film formation by a wet process. Further, the production method of the embodiment described above can be used tomore easily obtain an organic thin film having superior performance. The structural unit T1 is preferably an organic group represented by one of the formulas (1-1) or (1-2) described above. The structural unit T1 is more preferably an organic group represented by formula (1-3) described above.

In one embodiment, the structural unit T1 may include a structural unit having a polymerizable functional group Z represented by formula (I) and a structural unit having another polymerizable functional group. However, from the viewpoint of facilitating effective suppression of any deterioration in the performance of the organic thin film during film formation, the proportion of structural units represented by formula (I), based on the total of all the structural units T1, is preferably at least 50 mol%, more preferably at least 75 mol%, and even more preferably 85 mol% or greater. This proportion of structural units is most preferably 100 mol%.

In one embodiment, in addition to the structural unit T1 described above, the charge transport polymer may also contain a monovalent structural unit that does not have a polymerizable functional group (hereafter referred to as a structural unit T2). In those cases where the charge transport polymer has both the structural unit T1 and the structural unit T2, obtaining an organic thin film with superior performance using the production method of the embodiment described above becomes even easier.

The structural unit T2 may be any monovalent organic group that does not have a polymerizable functional group in the structure, and may be a monovalent organic group which, with the exception of the valence, has the same structure as the structural unit L and structural unit B described above. In one embodiment, from the viewpoint of imparting durability without impairing the charge transport properties, the structural unit T2 is preferably a substituted or unsubstituted aromatic hydrocarbon structure, and is more preferably a substituted or unsubstituted benzene structure.

A specific example of the structural unit T2 is shown below.

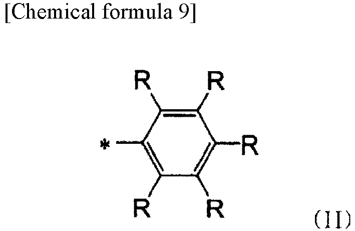

In the formula, R represents a hydrogen atom or a substituent. In the case of a substituent, R is the same as R described above in relation to the structural unit L (but excluding polymerizable functional groups). The symbol "*" denotes a bonding site with another structural unit. In one embodiment,R is preferably a linear, cyclic or branched alkyl group of 1 to 22 carbon atoms. The number of carbon atoms in the alkyl group is more preferably from 2 to 16, even more preferably from 3 to 12, and particularly preferably from 4 to 8. In another embodiment, a portion of the hydrogen atoms of the above alkyl group may each be substituted with a halogen atom such as a chlorine atom, a fluorine atom or a bromine atom.

Although there are no particular limitations, one embodiment of a preferred structural unit T2 is a structure of formula (II) in which one R group is an alkyl group and the other R groups are hydrogen atoms. Among such structures, structures in which the alkyl group is in the para-position relative to the bonding site with another structural unit are preferred, and structures in which the alkyl group has a linear structure are particularly preferred. The number of carbon atoms in the alkyl group is preferably from 2 to 16 carbon atoms, more preferably from 3 to 12 carbon atoms, and even more preferably from 4 to 8 carbon atoms.

Another embodiment of the structural unit T2 is a structure of formula (II) in which two of the R groups are alkyl groups and the other R groups are hydrogen atoms. Among such structures, structures in which the alkyl groups are in the meta-positions relative to the bonding site with another structural unit are preferred. In these types of structures, a portion or all of the hydrogen atoms of the alkyl groups may each be substituted with a halogen atom such as a chlorine atom, a fluorine atom or a bromine atom. Specific examples of alkyl groups that have been substituted with halogen atoms include -CF₃, -CH(CF₃)₂ and - CF(CF₃)₂, and of these, -CF₃ is preferred.

In one embodiment, from the viewpoint of enhancing the curability of the charge transport polymer, the proportion of the structural unit T1, based on the total of all the structural units T, is preferably at least 50 mol%, more preferably at least 75 mol%, and even more preferably 85 mol% or greater. This proportion of the structural unit T1 may be 100 mol%. In those cases where the charge transport polymer contains the structural unit represented by formula (I) and a structural unit containing another polymerizable functional group, the proportion of the structural unit T1 means the total of both these structural units.

In one embodiment, in those cases where the structural unit T2 is used in addition to the structural unit T1, the proportion of the structural unit T2, based on the total of all the structural units T (T1+T2) is preferably not more than 75 mol%, more preferably not more than 50 mol%, and even more preferably 25 mol% or less. On the other hand, the proportion of the structural unit T1 is preferably at least 25 mol%, more preferably at least 50 mol%, and even more preferably 75 mol% or greater. Adjusting the proportions of the structural units T1 and T2 to satisfy these respective ranges makes it even easier to obtain an organic thin film having excellent performance without impairing the curability.

In one embodiment, the charge transport polymer has at least one polymerizable functional group within the molecule, and at least one polymerizable functional group is the polymerizable functional group Z contained in the structural region represented by formula (I). The polymerizable functional group may be introduced at a terminal portion of the charge transport polymer (namely, a structural unit T), at a portion other than a terminal portion (namely, a structural unit L or B), or at both a terminal portion and a portion other than a terminal. From the viewpoint of the curability, the polymerizable functional group is preferably introduced at least at a terminal portion, and from the viewpoint of achieving a combination of favorable curability and charge transport properties, is preferably introduced only at terminal portions. Further, in those cases where the charge transport polymer has a branched structure, the polymerizable functional group may be introduced within the main chain of the charge transport polymer, within a side chain, or within both the main chain and a side chain.

From the viewpoint of contributing to the curability, the polymerizable functional group is preferably included in the charge transport polymer in a large amount. On the other hand, from the viewpoint of not impeding the charge transport properties, the amount included in the charge transport polymer is preferably kept small. The amount of the polymerizable functional group may be set as appropriate with due consideration of these factors.

For example, from the viewpoint of obtaining superior curability, the number of polymerizable functional groups per one molecule of the charge transport polymer is preferably at least 2, and more preferably 3 or greater. Further, from the viewpoint of maintaining good charge transport properties, the number of polymerizable functional groups is preferably not more than 1,000, and more preferably 500 or fewer. Here, the number of polymerizable functional groups means the total of the polymerizable functional group Z contained in the structural region represented by formula (I), and polymerizable functional groups contained in other structural regions.

The number of polymerizable functional groups per one molecule of the charge transport polymer can be determined as an average value using the ratio of the amount added of monomers having a polymerizable functional group relative to the total of the amounts added of the monomers corresponding with the various structural units, and the weight average molecular weight of the charge transport polymer and the like.

Further, the number of polymerizable functional groups can also be calculated as an average value using the ratio between the integral of the signal attributable to the polymerizable functional groups and the integral of the total spectrum in the ¹H-NMR (nuclear magnetic resonance) spectrum of the charge transport polymer, and the weight average molecular weight of the charge transport polymer and the like. In terms of simplicity, if the amounts added of the various components are clear, then the value determined using these amounts is preferably employed.

### (Number Average Molecular Weight)

The number average molecular weight of the charge transport polymer can be adjusted appropriately with due consideration of the solubility in solvents and the film formability and the like. From the viewpoint of ensuring superior charge transport properties, the number average molecular weight is preferably at least 500, more preferably at least 1,000, and even more preferably 2,000 or greater. Further, from the viewpoints of maintaining favorable solubility in solvents and facilitating the preparation of ink compositions, the number average molecular weight is preferably not more than 1,000,000, more preferably not more than 100,000, and even more preferably 50,000 or less. In one embodiment, the number average molecular weight of the charge transport polymer is preferably within a range from 5,000 to 40,000, more preferably from 8,000 to 30,000, and even more preferably from 10,000 to 20,000.

### (Weight Average Molecular Weight)

The weight average molecular weight of the charge transport polymer can be adjusted appropriately with due consideration of the solubility in solvents and the film formability and the like. From the viewpoint of ensuring superior charge transport properties, the weight average molecular weight is preferably at least 1,000, more preferably at least 5,000, and even more preferably 10,000 or greater. Further, from the viewpoints of maintaining favorable solubility in solvents and facilitating the preparation of ink compositions, the weight average molecular weight is preferably not more than 1,000,000, more preferably not more than 700,000, and even more preferably 400,000 or less. In one embodiment, the weight average molecular weight of the charge transport polymer is preferably within a range from 20,000 to 200,000, more preferably from 30,000 to 150,000, and even more preferably from 40,000 to 100,000.

The number average molecular weight and the weight average molecular weight can be measured by gel permeation chromatography (GPC) under the following conditions, using a calibration curve of standard polystyrenes.

Feed pump: L-6050, manufactured by Hitachi High-Technologies Corporation
UV-Vis detector: L-3000, manufactured by Hitachi High-Technologies Corporation
Columns: Gelpack (a registered trademark) GL-A160S / GL-A150S, manufactured by Hitachi Chemical Co., Ltd.
Eluent: THF (for HPLC, stabilizer-free), manufactured by Wako Pure Chemical Industries, Ltd.
Flow rate: 1 mL/min
Column temperature: room temperature
Molecular weight standards: standard polystyrenes

### (Proportions of Structural Units)

From the viewpoint of ensuring satisfactory charge transport properties, the proportion of the structural unit L contained in the charge transport polymer, relative to the total of all the structural units, is preferably at least 10 mol%, more preferably at least 20 mol%, and even more preferably 30 mol% or higher. If the structural unit T and the optionally included structural unit B are taken into consideration, then the proportion of the structural unit L is preferably not more than 95 mol%, more preferably not more than 90 mol%, and even more preferably 85 mol% or less.

From the viewpoint of improving the characteristics of the organic electronic element, or from the viewpoint of suppressing any increase in viscosity and enabling more favorable synthesis of the charge transport polymer, the proportion of the structural unit T contained in the charge transport polymer, relative to the total of all the structural units, is preferably at least 5 mol%, more preferably at least 10 mol%, and even more preferably 15 mol% or higher. Further, from the viewpoint of ensuring satisfactory charge transport properties, the proportion of the structural unit T is preferably not more than 60 mol%, more preferably not more than 55 mol%, and even more preferably 50 mol% or less. In one embodiment, the proportion of the structural unit T means the proportion of the structural unit T1 having a structural region represented by formula (I). In another embodiment, the proportion of the structural unit T means the proportion of the total of the structural unit T1 and other structural units T2.

In those cases where the charge transport polymer includes a structural unit B, from the viewpoint of improving the durability of the organic electronic element, the proportion of the structural unit B, relative to the total of all the structural units, is preferably at least 1 mol%, more preferably at least 5 mol%, and even more preferably 10 mol% or higher. Further, from the viewpoints of suppressing any increase in viscosity and enabling more favorable synthesis of the charge transport polymer, or from the viewpoint of ensuring satisfactory charge transport properties, the proportion of the structural unit B is preferably not more than 50 mol%, more preferably not more than 40 mol%, and even more preferably 30 mol% or less.

From the viewpoint of ensuring efficient curing of the charge transport polymer, the proportion of the polymerizable functional group in the charge transport polymer, relative to the total of all the structural units, is preferably at least 0.1 mol%, more preferably at least 1 mol%, and even more preferably 3 mol% or higher. Further, from the viewpoint of ensuring favorable charge transport properties, the proportion of the polymerizable functional group is preferably not more than 70 mol%, more preferably not more than 60 mol%, and even more preferably 50 mol% or less. Here, the "proportion of the polymerizable functional group" refers to the proportion of structural units having the polymerizable functional group. In those case where the charge transport polymer has the polymerizable functional group Z contained in the structural region represented by formula (I) and a polymerizable functional group in another structural region, the "proportion of the polymerizable functional group" refers to the proportion of the total of these polymerizable functional groups.

Considering the balance between the charge transport properties, the durability, and the productivity and the like, the ratio (molar ratio) between the structural unit L and the structural unit T is preferably L:T = 100:(1 to 70), more preferably 100:(3 to 50), and even more preferably 100:(5 to 30). Further, in those cases where the charge transport polymer also includes the structural unit B, the ratio (molar ratio) between the structural unit L, the structural unit T and the structural unit B is preferably L:T:B = 100:(10 to 200):(10 to 100), more preferably 100:(20 to 180):(20 to 90), and even more preferably 100:(40 to 160):(30 to 80).

The proportion of each structural unit can be determined from the amount added of the monomer corresponding with that structural unit during synthesis of the charge transport polymer. Further, the proportion of each structural unit can also be calculated as an average value using the integral of the spectrum attributable to the structural unit in the ¹H-NMR spectrum of the charge transport polymer. In terms of simplicity, if the amount added of the monomer is clear, then the proportion of the structural unit preferably employs the value determined using the amount added of the monomer.

When the charge transport polymer is a hole transport material, from the viewpoint of obtaining superior hole injection properties and hole transport properties, the polymer is preferably a compound that contains a unit having an aromatic amine structure and/or a unit having a carbazole structure as a main structural unit. From this viewpoint, the proportion of the total number of units having an aromatic amine structure and/or units having a carbazole structure relative to the total number of all the structural units in the polymer compound (but excluding the terminal structural units) is preferably at least 40%, more preferably at least 45%, and even more preferably 50% or greater. The proportion of the total number of units having an aromatic amine structure and/or units having a carbazole structure may be 100%.

In one embodiment, the charge transport polymer preferably contains a divalent and/or trivalent structural unit derived from a triphenylamine as an aromatic amine structure. In the triphenylamine structure, the benzene rings may have one or more substituents. In one embodiment, the charge transport polymer preferably contains a structural unit derived from a triphenylamine structure having an alkyl group or a halogen atom.

In one embodiment, the charge transport polymer preferably includes a structure illustrated below. In the following formulas, R represents an alkyl group or a halogen atom, with details being as described above. Further, -Ar-X-Y-Z is as described above for the structural region represented by formula (I).

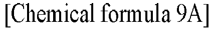

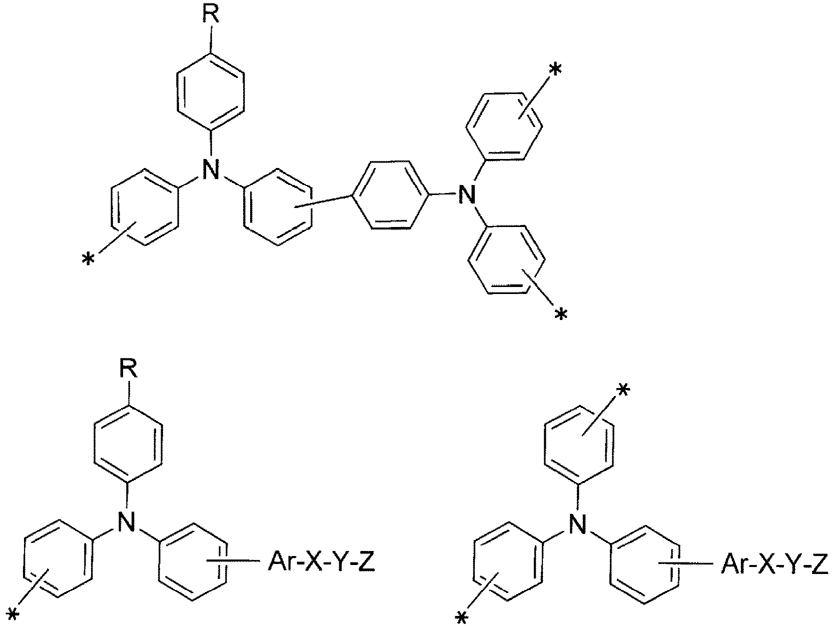

In one embodiment, the charge transport polymer preferably contains the structural unit L1 and the structural unit B1 described above. In the formulas, R is as described above for the structural unit LI.

The charge transport polymer of this embodiment tends to be less likely to suffer deterioration in the performance of the organic thin film as a result of the heating process during film formation. Accordingly, the charge transport polymer of the above embodiment can be used favorably in the production method of the embodiment described above, and the combination of this polymer and method enables an organic thin film having even more superiorperformance to be provided with ease. The charge transport polymer of this embodiment preferably contains, for example, a structure illustrated below. In the formula, R is as described above for the structural unit LI.

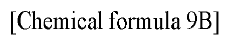

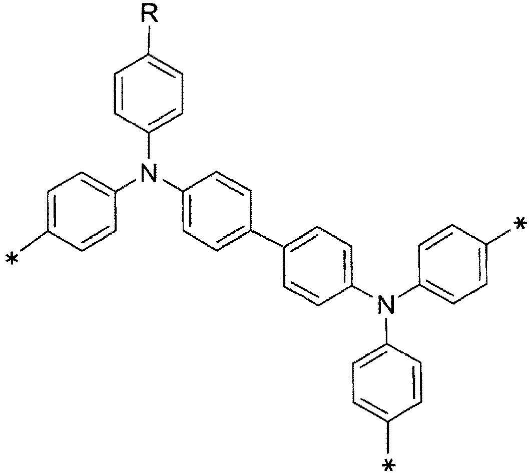

In one embodiment, the charge transport polymer more preferably contains structural units L1-1 and B1 represented by the formulas shown below.

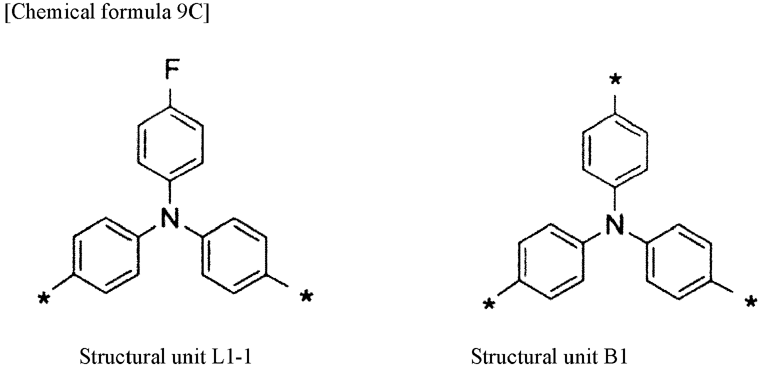

Further, the charge transport polymer preferably contains the above structural units L1-1 and B1, and a structural unit T1-1 represented by the formula shown below.

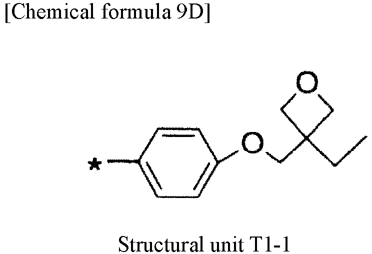

The charge transport polymer of the embodiment described above more preferably also contains a structural unit T2-1 or a structural unit T2-2 represented by the formulas shown below. In these formulas, R is as described above.

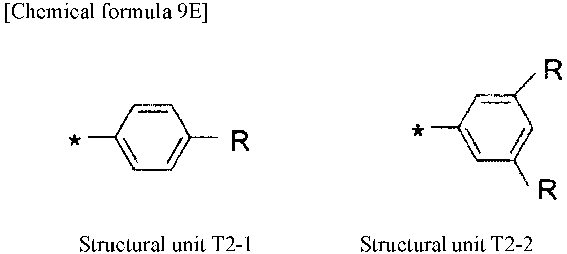

### (Production Method for Charge Transport Polymer)

The charge transport polymer can be produced by various synthesis methods, and there are no particular limitations. For example, conventional coupling reactions such as the Suzuki couplng, Negishi coupling, Sonogashira coupling, Stille coupling and Buchwald-Hartwig coupling reactions can be used. The Suzuki coupling is a reaction in which a cross-coupling reaction is initiated between an aromatic boronic acid derivative and an aromatic halide using a Pd catalyst. By using a Suzuki coupling, the charge transport polymer can be produced easily by bonding together the desired aromatic rings.

In the coupling reaction, a Pd(0) compound, Pd(II) compound, or Ni compound or the like isused as a catalyst. Further, a catalyst species generated by mixing a precursor such as tris(dibenzylideneacetone)dipalladium(0) or palladium(II) acetate with a phosphine ligand can also be used. Reference may also be made to WO 2010/140553 in relation b synthesis methods for the charge transport polymer.

### [Dopant]

The organic electronic material may also contain a dopant. There are no particular limitations on the dopant, provided it is a compound that yields a doping effect upon addition to tie organic electronic material, enabling an improvement in the charge transport properties. Doping includes both type doping and n-type doping. In p-type doping, a substance that functions as an electron acceptor is used as the dopant, whereas in n-type doping, a substance that functions as an electron donor is used as the dopant. To improve the hole transport properties, p-type doping is preferably used, whereas to improve the electron transport properties, n-type doping is preferably used. The dopantused in the organic electronic material may be a dopant that exhibits either a p-type doping effect or an n-type doping effect. Further, a single type of dopant may be added alone, or a mixture of a plurality of dopant types may be added.

The dopants used in p-type doping are electron-accepting compounds, and examples include Lewis acids, protonic acids, transition metal compounds, ionic compounds, halogen compounds and π-conjugated compounds. Specific examples include Lewis acids such as FeCl₃, PF₅, AsF₅, SbF₅, BF₅, BCl₃ and BBr₃; protonic acids, including inorganic acids such as HF, HCl, HBr, HNO₃, H₂SO₄ and HClO₄, and organic acids such as benzenesulfonic acid, p-toluenesulfonic acid, dodecylbenzenesulfonic acid, polyvinylsulfonic acid, methanesulfonic acid, trifluoromethanesulfonic acid, trifluoroacetic acid, 1-butanesulfonic acid, vinylphenylsulfonic acid and camphorsulfonic acid; transition metal compounds such as FeOCl, TiCl₄, ZrCl₄, HfCl₄, NbF₅, AlCl₃, NbCl₅, TaCl₅ and MoF₅; ionic compounds, including salts containing a perfluoro anion such as a tetrakis(pentafluorophenyl)borate ion, tris(trifluoromethanesulfonyl)methide ion, bis(trifluoromethanesulfonyl)imide ion, hexafluoroantimonate ion, AsF₆⁻ (hexafluoroarsenate ion), BF₄⁻ (tetrafluoroborate ion) or PF₆⁻ (hexafluorophosphate ion), and salts having a conjugate base of an aforementioned protonic acid as an anion; halogen compounds such as Cl₂, Br₂, I₂, ICl, ICl₃, IBr and IF; and π-conjugated compounds such as TCNE (tetracyanoethylene) and TCNQ (tetracyanoquinodimethane). Further, the electron-accepting compounds disclosed in JP 2000-36390 A, JP 2005-75948 A, and JP 2003-213002 A and the like can also be used. Lewis acids, ionic compounds, and π-conjugated compounds and the like are preferred, and ionic compounds are particularly preferred. Among the various ionic compounds, onium salts are preferred. The term "onium salt" means a compound having a cation portion including an onium ion such as an iodonium or ammonium ion, and an anion portion.

The dopants used in n-type doping are electron-donating compounds, and examples include alkali metals such as Li and Cs; alkaline earth metals such as Mg and Ca; salts of alkali metals and/or alkaline earth metals such as LiF and Cs₂CO₃; metal complexes; and electron-donating organic compounds.

In order to enhance the curability of the organic thin film, the use of a compound that can function as a polymerization initiator for the polymerizable functional group as the dopant is preferred. Examples of materials that combine a function as a dopant and a function as a polymerization initiator include the ionic compounds described above.

### [Other Optional Components]

The organic electronic material may also contain charge transport low-molecular weight compounds, or other charge transport polymers or the like.

### [Contents]

From the viewpoint of obtaining favorable charge transport properties, the amount of the charge transport compound, relative to the total mass of the organic electronic material, is preferably at least 50% by mass, more preferably at least 70% by mass, and even more preferably 80% by mass or greater. The amount may be 100% by mass.

When a dopant is included, from the viewpoint of improving the charge transport properties of the organic electronic material, the amount of the dopant relative to the total mass of the organic electronic material is preferably at least 0.01% by mass, more preferably at least 0.1% by mass, and even more preferably 0.5% by mass or greater. Further, from the viewpoint of maintaining favorable film formability, the amount of the dopant relative to the total mass of the organic electronic material is preferably not more than 50% by mass, more preferably not more than 30% by mass, and even more preferably 20% by mass or less.

### [Polymerization Initiator]

The organic electronic material preferably contains a polymerization initiator. Conventional radical polymerization initiators, cationic polymerization initiators, and anionic polymerization initiators and the like can be used as the polymerization initiator. From the viewpoint of enabling simple preparation of the ink composition, the use of a substance that exhibits both a function as a dopant and a function as a polymerization initiator is preferred. Examples of polymerization initiators that also exhibit a function as a dopant include the ionic compounds described above. Among the ionic compounds, onium salts are preferred. The term "onium salt" means a compound having a cation portion including an onium ion such as an iodonium or ammonium ion, and an anion portion. Examples include compounds having a perfluoro anion portion, and specific examples include the compounds shown below.

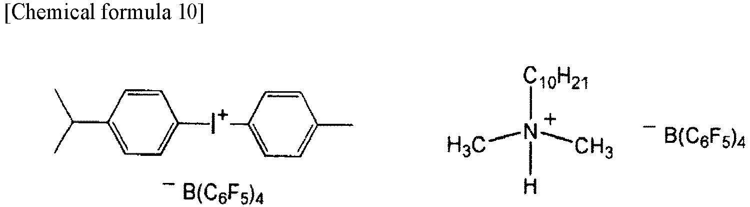

### <Ink Composition>

The organic electronic material may be used in the form of an ink composition containing the organic electronic material of the embodiment described above and a solvent capable of dissolving or dispersing the material. By using this type of ink composition, an organic thin film can be formed easily using a simple coating method.

### [Solvent]

Water, organic solvents, or mixed solvents thereof can be used as the solvent. Examples of the organic solvent include alcohols such as methanol, ethanol and isopropyl alcohol; alkanes such as pentane, hexane and octane; cyclic alkanes such as cyclohexane; aromatic hydrocarbons such as benzene, toluene, xylene, mesitylene, tetralin and diphenylmethane; aliphatic ethers such as ethylene glycol dimethyl ether, ethylene glycol diethyl ether and propylene glycol-1-monomethyl ether acetate; aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole and 2,4-dimethylanisole; aliphatic esters such as ethyl acetate, n-butyl acetate, ethyl lactate and n-butyl lactate; aromatic esters such as phenyl acetate, phenyl propionate, methyl benzoate, ethyl benzoate, propyl benzoate and n-butyl benzoate; amide-based solvents such as N,N-dimethylformamide and N,N-dimethylacetamide; as well as dimethyl sulfoxide, tetrahydrofuran, acetone, chloroform and methylene chloride and the like. Preferred solvents include aromatic hydrocarbons, aliphatic esters, aromatic esters, aliphatic ethers, and aromatic ethers and the like.

### [Additives]

The ink composition may also contain additives as optional components. Examples of these additives include polymerization inhibitors, stabilizers, thickeners, gelling agents, flame retardants, antioxidants, reduction inhibitors, oxidizing agents, reducing agents, surface modifiers, emulsifiers, antifoaming agents, dispersants and surfactants.

### [Contents]

The amount of the solvent in the ink composition can be determined with due consideration of the use of the composition in various application methods. For example, the amount of the solvent is preferably an amount that yields a ratio of the charge transport polymer relative to the solvent that is at least 0.1% by mass, more preferably at least 0.2% by mass, and even more preferably 0.5% by mass or greater. Further, the amount of the solvent is preferably an amount that yields a ratio of the charge transport polymer relative to the solvent that is not more than 20% by mass, more preferably not more than 15% by mass, and even more preferably 10% by mass or less.

### <Organic Thin Film>

The organic thin film that represents one embodiment of the present invention relates to an organic thin film produced using the production method of the embodiment described above. In other words, the organic thin film is obtained by conducting heating under an inert gas atmosphere following formation of a coating film, and is a film for which little deterioration occurs in the characteristics of the organic thin film during film formation, enabling the inherent characteristics of the film to be obtained. Accordingly, by producing an organic electronic element sing this type of organic thin film, excellent element characteristics can be achieved.

From the viewpoint of improving the charge transport efficiency, the thickness of the organic thin film following drying or curing is preferably at least 0.1 nm, more preferably at least 1 nm, and even more preferably 3 nm or greater. Further, from the viewpoint of reducing the electrical resistance, the thickness of the organic thin film is preferably not more than 300 nm, more preferably not more than 200 nm, and even more preferably 100 nm or less.

For reasons of cost, formation of an organic thin film using a wet process is typically conducted in an open atmosphere. Particularly in those cases where an organic thin film is formed as a hole injection layer or a hole transport layer during production of an organic EL element, it has been thought that forming the organic thin film in an open atmosphere was also preferable from the viewpoint of an oxygen doping effect. However, investigations by the inventors of the present invention revealed clearly that when forming an organic thin film as a hole injection layer or a hole transport layer, conducting heating of the coating film under an inert gas atmosphere enabled an improvement in the performance of the organic thin film. Although not constrained by any particular theory, it is thought that by conducting the heating of the coating film under an inert gas atmosphere, the effects of the atmosphere on the heating process are reduced, and thermal degradation and surface oxidation of the organic thin film are suppressed, meaning the inherent performance of the organic thin film can be more easily maintained. Although not a particular limitation, the organic thin film of this embodiment is preferably formed as a hole injection layer or a hole transport layer adjacent to the anode.

### <Laminate>

A laminate that represents one embodiment of the present invention has an organic thin film formed from an organic electronic material containing a charge transport compound, and an upper layer provided on top of the organic thin film. In this laminate, it is preferable that the dispersion in the oxygen atom distribution through the depth direction including the interface between the organic thin film and the upper layer, calculated by irradiating a gas cluster ion beam onto the laminate from the side of the upper layer and measuring the oxygen ion intensity through the depth direction with a time-of-flight secondary ion mass spectrometer, is within a range from 1.0% to 8.0%. It is thought that when this dispersion in the oxygen atom distribution through the depth direction is 8.0% or less, surface oxidation of the organic thin film is suppressed, and superior element characteristics can be more easily obtained in an organic EL element.

The dispersion in the oxygen atom distribution described above can be determined, specifically, in the manner described below.
(1) A gas cluster ion beam is irradiated onto the laminate from the side of the upper layer, and the oxygen ion intensity through the depth direction is measured with a time-of-flight secondary ion mass spectrometer.
(2) Using the profile obtained from the measurement, the average value A and the standard deviation B for the oxygen ion intensity in the depth direction are determined for a fixed range in the depth direction (the film thickness direction), for example a range of 10 to 40 nm, that includes the interface between the organic thin film and the upper layer. Subsequently, using the average value A and the standard deviation B, the dispersion (B/A) in the oxygen atom distribution is determined as a percentage (%).

It is thought that a smaller value for this dispersion (%) in the oxygen atom distribution through the depth direction, determined in the manner described above, indicates less surface oxidation of the organic thin film, and better suppression of any deterioration in the performance of the organic thin film during film formation. Accordingly, in one embodiment, the dispersion in the oxygen atom distribution through the depth direction is more preferably not more than 7.0%, even more preferably not more than 5.0%, and still more preferably 4.0% or less. A laminate in which there is substantially no dispersion in the oxygen atom distribution is the most desirable.

In one embodiment, the organic thin film of the above laminate may be an organic thin film formed from the organic electronic material described above. Among the various possibilities, an organic thin film formed from an organic electronic material containing a charge transport compound having the structural unit T1 is preferred. An organic thin film formed from an organic electronic material containing a charge transport compound having the structural unit T1 and the structural unit T2 is more preferred. The organic thin film may be produced using any appropriate film formation method, but when formation is performed in accordance with the method for producing an organic thin film of the embodiment described above, a laminate having a dispersion in the oxygen atom distribution through the depth direction that satisfies the above range can be more easily obtained.

In the above laminate, the upper layer may be a thin film formed from any arbitrary material. The upper layer is preferably a thin film formed from an organic electronic material. In one embodiment, the upper layer of the laminate may be an organic thin film formed from the organic electronic material described above. Among the various possibilities, the upper layer is preferably an organic thin film formed from an organic electronic material containing a charge transport compound having a structural unit T1 that differs from the material that constitutes the organic thin film of the lower layer. The organic thin film of the upper layer is more preferably an organic thin film formed from an organic electronic material containing a charge transport compound having the structural unit T1 and the structural unit T2. In another embodiment, the upper layer may be an organic thin film formed from an organic electronic material containing a charge transport compound that does not include the structural unit T1 (and does not have a polymerizable functional group). The upper layer may be produced using any appropriate film formation method, but when formation is performed in accordance with the method for producing an organic thin film of the embodiment described above, a laminate having a dispersion in the oxygen atom distribution through the depth direction that satisfies the above range can be more easily obtained.

In one embodiment, the laminate is preferably a laminate having a first organic thin film and a second organic thin film, and is more preferably a laminate having a hole injection layer and a hole transport layer. It is thought that when an organic electronic element is produced using this type of laminate, the desired superior element characteristics can be more easily obtained.

### <Organic Electronic Element>

An organic electronic element that represents one embodiment of the present invention has at least the organic thin film or the laminate of one of the embodiments described above. Examples of the organic electronic element include an organic EL element, an organic photoelectric conversion element, and an organic transistor. The organic electronic element preferably has at least a structure in which the organic thin film is disposed between a pair of electrodes representing an anode and a cathode.

### [Organic EL Element]

An organic EL element of the embodiment described above has at least the organic thin film of the embodiment described above. The organic EL element typically includes a light-emitting layer, an anode, a cathode and a substrate, and if necessary, may also have other functional layers such as a hole injection layer, an electron injection layer, a hole transport layer or an electron transport layer. Each layer may be formed by a vapor deposition method, or by a coating method. The organic EL element preferably has the organic thin film as the light-emitting layer or as another functional layer, more preferably has the organic thin film as a functional layer, and even more preferably has the organic thin film as at least one of a hole injection layer and a hole transport layer.

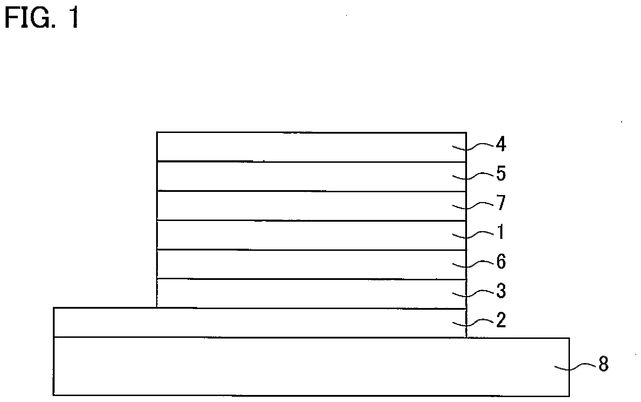

FIG. 1 is a cross-sectional schematic view illustrating one embodiment of the organic EL element. The organic EL element in FIG. 1 is an element with a multilayer structure, and has a substrate 8, an anode 2, a hole injection layer 3 and a hole transport layer 6 each formed from an organic thin film of the embodiment described above, a light-emitting layer 1, an electron transport layer 7, an electron injection layer 5 and a cathode 4 provided in that order. In FIG. 1, the hole injection layer 3 and the hole transport layer 6 are organic thin films formed using the production method of the embodiment described above. However, the organic EL element of an embodiment of the present invention is not limited to this type of structure, and another layer may be an organic thin film formed using the production method of the embodiment described above. Each of the layers is described below.

### [Light-Emitting Layer]

Examples of materials that can be used for the light-emitting layer include low-molecular weight compounds, polymers, and dendrimers and the like. Polymers exhibit good solubility in solvents, meaning they are suitable for coating methods, and are consequently preferred. Examples of the light-emitting material include fluorescent materials, phosphorescent materials, and thermally activated delayed fluorescent materials (TADF).

Specific examples of the fluorescent materials include low-molecular weight compounds such as perylene, coumarin, rubrene, quinacridone, stilbene, color laser dyes, aluminum complexes, and derivatives of these compounds; polymers such as polyfluorene, polyphenylene, polyphenylenevinylene, polyvinylcarbazole, fluorene-benzothiadiazole copolymers, fluorene-triphenylamine copolymers, and derivatives of these compounds; and mixtures of the above materials.

Examples of materials that can be used as the phosphorescent materials include metal complexes and the like containing a metal such as Ir or Pt or the like. Specific examples of Ir complexes include FIr(pic) (iridium(III) bis[(4,6-difluorophenyl)-pyridinato-N,C²]picolinate) which emits blue light, Ir(ppy)₃ (fac-tris(2-phenylpyridine)iridium) which emits green light, and (btp)₂Ir(acac) (bis[2-(2'-benzo[4,5-α]thienyl)pyridinato-N,C³]iridium(acetyl-acetonate)) and Ir(piq)₃ (tris(1-phenylisoquinoline)iridium) which emit red light. Specific examples of Pt complexes include PtOEP (2,3,7,8,12,13,17,18-octaethyl-21H,23H-porphyrin-platinum) which emits red light.

When the light-emitting layer contains a phosphorescent material, a host material is preferably also included in addition to the phosphorescent material. Low-molecular weight compounds, polymers, and dendrimers can be used as this host material. Examples of the low-molecular weight compounds include CBP (4,4'-bis(9H-carbazol-9-yl)-biphenyl), mCP (1,3-bis(9-carbazolyl)benzene), CDBP (4,4'-bis(carbazol-9-yl)-2,2'-dimethylbiphenyl), and derivatives of these compounds, whereas examples of the polymers include the organic electronic material of the embodiment described above, polyvinylcarbazole, polyphenylene, polyfluorene, and derivatives of these polymers.

Examples of the thermally activated delayed fluorescent materials include the compounds disclosed in Adv. Mater., 21, 4802-4906 (2009); Appl. Phys. Lett., 98, 083302 (2011); Chem. Comm., 48, 9580 (2012); Appl. Phys. Lett., 101, 093306 (2012); J. Am. Chem. Soc., 134, 14706 (2012); Chem. Comm., 48, 11392 (2012); Nature, 492, 234 (2012); Adv. Mater., 25, 3319 (2013); J. Phys. Chem. A, 117, 5607 (2013); Phys. Chem. Chem. Phys., 15, 15850 (2013); Chem. Comm., 49, 10385 (2013); and Chem. Lett., 43, 319 (2014) and the like.

### [Hole Injection Layer, Hole Transport Layer]

In FIG. 1, at least one of the hole injection layer 3 and the hole transport layer 6 is preferably an organic thin film formed using the production method of the embodiment described above. However, the organic EL element is not limited to this type of structure, and another functional layer may be an organic thin film formed using the production method of the embodiment described above. In one embodiment, the organic thin film is preferably used as at least one of a hole transport layer and a hole injection layer, and is more preferably used as at least a hole injection layer.

In those cases where the organic thin film is used for a hole injection layer and a hole transport layer, examples of the organic electronic material used during film formation include aromatic amine-based compounds (for example, aromatic diamines such as N,N'-di(naphthalen-1-yl)-N,N'-diphenyl-benzidine (α-NPD)), phthalocyanine-based compounds, and thiophene-based compounds (for example, thiophene-based conductive polymers (such as poly(3,4-ethylenedioxythiophene):poly(4-styrenesulfonate) (PEDOT:PSS) and the like). Preferred embodiments of the organic electronic material are as described above.

### [Electron Transport Layer, Electron Injection Layer]

Examples of materials that can be used for the electron transport layer and the electron injection layer include phenanthroline derivatives, bipyridine derivatives, nitro-substituted fluorene derivatives, diphenylquinone derivatives, thiopyran dioxide derivatives, condensed-ring tetracarboxylic acid anhydrides of naphthalene and perylene and the like, carbodiimides, fluorenylidenemethane derivatives, anthraquinodimethane and anthrone derivatives, oxadiazole derivatives, thiadiazole derivatives, benzimidazole derivatives (for example, 2,2',2"-(1,3,5-benzenetriyl)tris(1-phenyl-1H-benzimidazole) (TPBi)), quinoxaline derivatives, and aluminum complexes (for example, aluminum bis(2-methyl-8-quinolinolate)-4-(phenylphenolate) (BAlq) and aluminum tris(8-quinolinolate (ALq₃)). Further, the organic electronic material described above may also be used.

### [Cathode]

Examples of the cathode material include metals or metal alloys, such as Li, Ca, Mg, Al, In, Cs, Ba, Mg/Ag, LiF and CsF.

### [Anode]

Metals (for example, Au) or other materials having conductivity can be used as the anode. Examples of the other materials include oxides (for example, ITO: indium oxide/tin oxide), and conductive polymers (for example, polythiophene-polystyrene sulfonate mixtures (PEDOT:PSS)).

### [Substrate]

Glass and plastics and the like can be used as the substrate. The substrate is preferably transparent, and a substrate having flexibility is preferred. Quartz glass and light-transmitting resin films and the like can be used particularly favorably.

Examples of the resin films include films composed of polyethylene terephthalate, polyethylene naphthalate, polyethersulfone, polyetherimide, polyetheretherketone, polyphenylene sulfide, polyarylate, polyimide, polycarbonate, cellulose triacetate or cellulose acetate propionate.

In those cases where a resin film is used, an inorganic substance such as silicon oxide or silicon nitride may be coated onto the resin film to inhibit the transmission of water vapor and oxygen and the like.

### [Emission Color]

There are no particular limitations on the color of the light emission from the organic EL element. White organic EL elements can be used for various illumination fixtures, including domestic lighting, in-vehicle lighting, watches and liquid crystal backlights, and are consequently preferred.

The method used for forming a white organic EL element may employ a method in which a plurality of light-emitting materials are used to emit a plurality of colors simultaneously, which are then mixed to obtain a white light emission. There are no particular limitations on the combination of the plurality of emission colors, and examples include combinations that include three maximum emission wavelengths for blue, green and red, and combinations that include two maximum emission wavelengths for blue and yellow, or for yellowish green and orange or the like. Control of the emission color can be achieved by appropriate adjustment of the types and amounts of the light-emitting materials.

In one embodiment, the method for producing an organic EL element has a step of forming an organic thin film between an anode and a cathode using the method for producing an organic thin film of the embodiment described above. Although not a particular limitation, the organic thin film is preferably formed as a hole injection layer or a hole transport layer. From this viewpoint, in one embodiment, the organic EL element preferably has the organic thin film adjacent to the anode and then the light-emitting layer in that sequence. The method for producing an organic electroluminescent element of the embodiment described above has a step of forming an organic thin film on an anode using the method for producing an organic thin film of the embodiment described above, a step of forming a light-emitting layer, and a step of forming a cathode. In the embodiment described above, the steps of forming the light-emitting layer and the cathode may be conducted using typical film formation methods used in the technical field. For example, either a coating method or a vapor deposition method may be used, although from the viewpoint of the characteristics of the types of materials that can be used, a vapor deposition method is preferred. In another embodiment, the above step of forming an organic thin film may be repeated to form a multilayer organic thin film.

### <Display Element, Illumination Device, Display Device>

In one embodiment, a display element contains the organic EL element of the embodiment described above. For example, by using the organic EL element as the element corresponding with each color pixel of red, green and blue (RGB), a color display element can be obtained. Examples of the image formation method include a simple matrix in which organic EL elements arrayed in a panel are driven directly by an electrode arranged in a matrix, and an active matrix in which a thin-film transistor is positioned on, and drives, each element.

Further, in one embodiment, an illumination device contains the organic EL element of an embodiment of the present invention. Moreover, in another embodiment, a display device contains the illumination device and a liquid crystal element as a display unit. For example, the display device may be a device that uses the illumination device of the embodiment described above as a backlight, and uses a conventional liquid crystal element as the display unit, namely a liquid crystal display device.

### EXAMPLES

Embodiments of the present invention are described below in further detail using a series of examples, but the present invention is not limited by the following examples, and includes all manner of modifications.

### <Preparation of Hole Transport Polymers>

### (Preparation of Pd Catalyst)

In a glove box under a nitrogen atmosphere at room temperature, tris(dibenzylideneacetone)dipalladium (73.2 mg, 80 µmol) was weighed into a sample tube, toluene (15 mL) was added, and the resulting mixture was agitated for 30 minutes. In a similar manner, tris(t-butyl)phosphine (129.6 mg, 640 µmol) was weighed into a sample tube, toluene (5 mL) was added, and the resulting mixture was agitated for 5 minutes. The two solutions were then mixed together, stirred for 30 minutes at room temperature, and then used as a catalyst. All the solvents used in the catalyst preparation were deaerated by nitrogen bubbling for at least 30 minutes prior to use.

The monomers used in each of the hole transport polymer preparations described below were as follows.

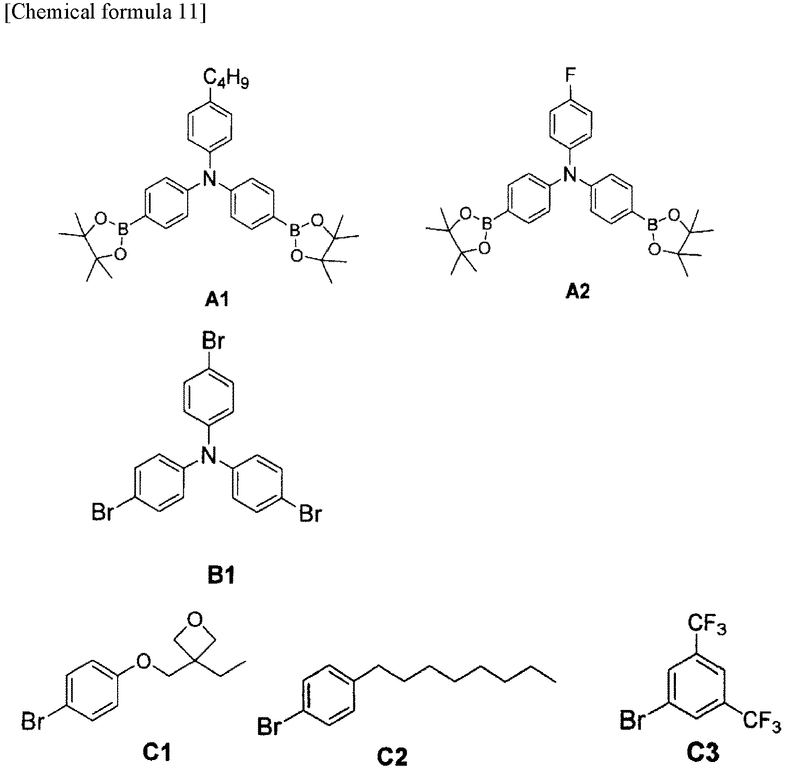

### (Preparation of Hole Transport Polymer 1)

A three-neck round-bottom flask was charged with the monomer A1 (5.0 mmol), the monomer B1 (2.0 mmol), the monomer C1 (4.0 mmol), methyl tri-n-octyl ammonium chloride ("Aliquat 336" manufactured by Alfa Aesar Ltd.) (0.03 g), potassium hydroxide (1.12 g), pure water (5.54 mL) and toluene (50 mL), the prepared Pd catalyst toluene solution (3.0 mL) was then added and mixed, and the resulting mixture was reacted by heating under reflux for two hours. All the operations up to this point were conducted under a stream of nitrogen. Further, all of the solvents were deaerated by nitrogen bubbling for at least 30 minutes prior to use.

After completion of the above reaction, the organic layer was washed with water and then poured into methanol-water (9:1). The resulting precipitate was collected by filtration under reduced pressure, and washed with methanol-water (9:1). The thus obtained precipitate was dissolved in toluene, and re-precipitated from methanol. The obtained precipitate was then collected by filtration under reduced pressure and dissolved in toluene, and a metal adsorbent ("Triphenylphosphine, polymer-bound on styrenedivinylbenzene copolymer", manufactured by Strem Chemicals Inc., 200 mg per 100 mg of the precipitate) was then added to the solution and stirred at 80°C for 2 hours.

Following completion of the stirring, the metal adsorbent and other insoluble matter were removed by filtration, and the filtrate was re-precipitated from methanol. The thus produced precipitate was collected by filtration under reduced pressure, and washed with methanol. The thus obtained precipitate was then dried under vacuum, yielding a hole injection compound 1. As described below, the molecular weight was measured by GPC (relative to polystyrene standards) using THF as the eluent. The obtained hole transport polymer 1 had a number average molecular of 14,700 and a weight average molecular weight of 46,100.

The number average molecular weight and the weight average molecular weight were measured by GPC (relative to polystyrene standards) using tetrahydrofuran (THF) as the eluent. The measurement conditions were as follows.

Feed pump: L-6050, manufactured by Hitachi High-Technologies Corporation
UV-Vis detector: L-3000, manufactured by Hitachi High-Technologies Corporation
Columns: Gelpack (a registered trademark) GL-A160S / GL-A150S, manufactured by Hitachi Chemical Co., Ltd.
Eluent: THF (for HPLC, stabilizer-free), manufactured by Wako Pure Chemical Industries, Ltd.
Flow rate: 1 mL/min
Column temperature: room temperature
Molecular weight standards: standard polystyrenes

### (Preparation of Hole Transport Polymer 2)

A three-neck round-bottom flask was charged with the monomer A2 (5.0 mmol), the monomer B1 (2.0 mmol), the monomer C1 (2.0 mmol), the monomer C2 (2.0 mmol), methyl tri-n-octyl ammonium chloride ("Aliquat 336" manufactured by Alfa Aesar Ltd.) (0.03 g), potassium hydroxide (1.12 g), pure water (5.54 mL) and toluene (50 mL), the prepared Pd catalyst toluene solution (3.0 mL) was then added and mixed, and the resulting mixture was reacted by heating under reflux for two hours. All the operations up to this point were conducted under a stream of nitrogen. Further, all of the solvents were deaerated by nitrogen bubbling for at least 30 minutes prior to use. Thereafter, the same operations as those described for the hole transport polymer 1 were conducted to obtain a hole transport polymer 2. The thus obtained hole transport polymer 2 had a number average molecular of 13,800 and a weight average molecular weight of 50,100.

### (Preparation of Hole Transport Polymer 3)

A three-neck round-bottom flask was charged with the monomer A2 (5.0 mmol), the monomer B1 (2.0 mmol), the monomer C1 (2.0 mmol), the monomer C3 (2.0 mmol), methyl tri-n-octyl ammonium chloride ("Aliquat 336" manufactured by Alfa Aesar Ltd.) (0.03 g), potassium hydroxide (1.12 g), pure water (5.54 mL) and toluene (50 mL), the prepared Pd catalyst toluene solution (3.0 mL) was then added and mixed, and the resulting mixture was reacted by heating under reflux for two hours. All the operations up to this point were conducted under a stream of nitrogen. Further, all of the solvents were deaerated by nitrogen bubbling for at least 30 minutes prior to use. Thereafter, the same operations as those described for the hole transport polymer 1 were conducted to obtain a hole transport polymer 3. The thus obtained hole transport polymer 3 had a number average molecular of 15,000 and a weight average molecular weight of 51,300.

### <Production and Evaluation of Organic Hole-Only Devices (HOD)>

The following description relates to the production of organic HODs that includes an organic thin film formation step, and the evaluation of the conductivity of the produced HODs.

### 1. Production of Organic HODs

### (Example 1)

In an open atmosphere, 51 µL of a solution prepared by mixing a polymerization initiator 1 shown below (5.0 mg) and toluene (2.5 mL) was added to and mixed with a solution containing the hole transport polymer 1 (10.0 mg) mixed with toluene (516 µL), thus preparing an ink composition 1. Further, the hole transport polymer 1 (10.0 mg) was mixed with toluene (2,301 µL) to prepare an ink composition 2.

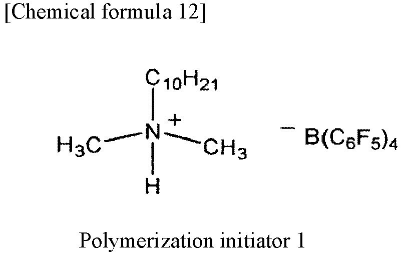

The ink composition 1 was spin-coated at 3,000 min⁻¹ in an open atmosphere (25°C) onto a glass substrate on which ITO had been patterned with a width of 1.6 mm, thus forming a coating film. Subsequently, the glass substrate with the coating film was placed in a nitrogen atmosphere and heated on a hot plate at 200°C for 30 minutes to cure the coating film, thus forming an organic thin film (hole injection layer) having a thickness of 80 nm.

Subsequently, the ink composition 2 was spin-coated at 3,000 min⁻¹ in an open atmosphere (25°C) onto the top of the above hole injection layer to form a coating film. The glass substrate with the coating film was then placed in a nitrogen atmosphere and heated on a hot plate at 230°C for 30 minutes to cure the coating film, thus forming an organic thin film (hole transport layer) having a thickness of 20 nm.

The glass substrate having an ITO / hole injection layer / hole transport layer structure obtained in this manner was transferred to a vacuum deposition apparatus,Al (100 nm) was deposited on top of the hole transport layer by vapor deposition to form an Al electrode, and an encapsulation treatment was then performed to obtain an organic HOD (1A).

### (Comparative Example 1)

With the exception of conducting the heating of the coating film during the formation of the hole injection layer (the lower organic thin film) in an open atmosphere, an organic HOD (1B) was produced using the same production method as that described for the organic HOD (1A) of Example 1. In other words, first, in the same manner as described for Example 1, the ink composition 1 was spin-coated at 3,000 min⁻¹ in an open atmosphere onto a glass substrate on which ITO had been patterned with a width of 1.6 mm, thus forming a coating film.

Subsequently, the glass substrate with the coating film was heated on a hot plate at 200°C for 30 minutes in an open atmosphere to cure the coating film, thus forming an organic thin film (hole injection layer) having a thickness of 80 nm. Thereafter, the same procedure as Example 1 was used to form a hole transport layer and an Al electrode on top of the hole injection layer, and then conduct an encapsulation treatment to obtain the organic HOD (1B).

### (Example 2)

In an open atmosphere, 51 µL of a solution prepared by mixing the polymerization initiator 1 shown above (5.0 mg) and toluene (2.5 mL) was added to and mixed with a solution containing the hole transport polymer 2 (10.0 mg) mixed with toluene (516 µL), thus preparing an ink composition 3. Further, the hole transport polymer 2 (10.0 mg) was mixed with toluene (2,301 µL) to prepare an ink composition 4.

The ink composition 3 was spin-coated at 3,000 min⁻¹ in an open atmosphere (25°C) onto a glass substrate on which ITO had been patterned with a width of 1.6 mm, thus forming a coating film. Subsequently, the glass substrate with the coating film was placed in a nitrogen atmosphere and heated on a hot plate at 200°C for 30 minutes to cure the coating film, thus forming an organic thin film (hole injection layer) having a thickness of 80 nm.

Subsequently, the ink composition 4 was spin-coated at 3,000 min⁻¹ in an open atmosphere (25°C) onto the top of the above hole injection layer to form a coating film. The glass substrate with the coating film was then placed in a nitrogen atmosphere and heated on a hot plate at 230°C for 30 minutes to cure the coating film, thus forming an organic thin film (hole transport layer) having a thickness of 20 nm.

The glass substrate having an ITO / hole injection layer / hole transport layer structure obtained in this manner was transferred to a vacuum deposition apparatus, Al (100 nm) was deposited on top of the hole transport layer by vapor deposition to form an Al electrode, and an encapsulation treatment was then performed to obtain an organic HOD (2A).

### (Comparative Example 2)

With the exception of conducting the heating of the coating film during the formation of the hole injection layer (the lower organic thin film) in an open atmosphere, an organic HOD (2B) was produced using the same production method as that described for the organic HOD (2A) of Example 2. In other words, first, in the same manner as described for Example 2, the ink composition 3 was spin-coated at 3,000 min⁻¹ in an open atmosphere onto a glass substrate on which ITO had been patterned with a width of 1.6 mm, thus forming a coating film.

Subsequently, the glass substrate with the coating film was heated on a hot plate at 200°C for 30 minutes in an open atmosphere to cure the coating film, thus forming an organic thin film (hole injection layer) having a thickness of 80 nm. Thereafter, the same procedure as Example 2 was used to form a hole transport layer and an Al electrode on top of the hole injection layer, and then conduct an encapsulation treatment to obtain the organic HOD (2B).

### (Example 3)

In an open atmosphere, 51 µL of a solution prepared by mixing the polymerization initiator 1 shown above (5.0 mg) and toluene (2.5 mL) was added to and mixed with a solution containing the hole transport polymer 3 (10.0 mg) mixed with toluene (516 µL), thus preparing an ink composition 5. Further, the hole transport polymer 3 (10.0 mg) was mixed with toluene (2,301 µL) to prepare an ink composition 6.

The ink composition 5 was spin-coated at 3,000 min⁻¹ in an open atmosphere (25°C) onto a glass substrate on which ITO had been patterned with a width of 1.6 mm, thus forming a coating film. Subsequently, the glass substrate with the coating film was placed in a nitrogen atmosphere and heated on a hot plate at 200°C for 30 minutes to cure the coating film, thus forming an organic thin film (hole injection layer) having a thickness of 80 nm.

Subsequently, the ink composition 6 was spin-coated at 3,000 min⁻¹ in an open atmosphere (25°C) onto the top of the above hole injection layer to form a coating film. The glass substrate with the coating film was then placed in a nitrogen atmosphere and heated on a hot plate at 230°C for 30 minutes to cure the coating film, thus forming an organic thin film (hole transport layer) having a thickness of 20 nm.

The glass substrate having an ITO / hole injection layer / hole transport layer structure obtained in this manner was transferred to a vacuum deposition apparatus, Al (100 nm) was deposited on top of the hole transport layer by vapor deposition to form an Al electrode, and an encapsulation treatment was then performed to obtain an organic HOD (3A).

### (Comparative Example 3)

With the exception of conducting the heating of the coating film during the formation of the hole injection layer (the lower organic thin film) in an open atmosphere, an organic HOD (3B) was produced using the same production method as that described for the organic HOD (3A) of Example 3. In other words, first, in the same manner as described for Example 3, the ink composition 5 was spin-coated at 3,000 min⁻¹ in an open atmosphere onto a glass substrate on which ITO had been patterned with a width of 1.6 mm, thus forming a coating film.

Subsequently, the glass substrate with the coating film was heated on a hot plate at 200°C for 30 minutes in an open atmosphere to cure the coating film, thus forming an organic thin film (hole injection layer) having a thickness of 80 nm. Thereafter, the same procedure as Example 3 was used to form a hole transport layer and an Al electrode on top of the hole injection layer, and then conduct an encapsulation treatment to obtain the organic HOD (3B).

### (Example 4)

In an open atmosphere, 51 µL of a solution prepared by mixing the polymerization initiator 1 shown above (5.0 mg) and toluene (2.5 mL) was added to and mixed with a solution containing the hole transport polymer 1 (10.0 mg) mixed with toluene (516 µL), thus preparing an ink composition 1. Further, the hole transport polymer 1 (10.0 mg) was mixed with toluene (2,301 µL) to prepare an ink composition 2.

The ink composition 1 was spin-coated at 3,000 min⁻¹ in an open atmosphere (25°C) onto a glass substrate on which ITO had been patterned with a width of 1.6 mm, thus forming a coating film. Subsequently, the glass substrate with the coating film was placed in a nitrogen atmosphere and heated on a hot plate at 200°C for 60 minutes to cure the coating film, thus forming an organic thin film (hole injection layer) having a thickness of 80 nm.

Subsequently, the ink composition 2 was spin-coated at 3,000 min⁻¹ in an open atmosphere (25°C) onto the top of the above hole injection layer to form a coating film. The glass substrate with the coating film was then placed in a nitrogen atmosphere and heated on a hot plate at 230°C for 30 minutes to cure the coating film, thus forming an organic thin film (hole transport layer) having a thickness of 20 nm.

The glass substrate having an ITO / hole injection layer / hole transport layer structure obtained in this manner was transferred to a vacuum deposition apparatus, Al (100 nm) was deposited on top of the hole transport layer by vapor deposition to form an Al electrode, and an encapsulation treatment was then performed to obtain an organic HOD (4A).

### (Comparative Example 4)

With the exception of conducting the heating of the coating film during the formation of the hole injection layer (the lower organic thin film) in an open atmosphere, an organic HOD (4B) was produced using the same production method as that described for the organic HOD (4A) of Example 4. In other words, first, in the same manner as described for Example 4, the ink composition 1 was spin-coated at 3,000 min⁻¹ in an open atmosphere onto a glass substrate on which ITO had been patterned with a width of 1.6 mm, thus forming a coating film. Subsequently, the glass substrate with the coating film was heated on a hot plate at 200°C for 60 minutes in an open atmosphere to cure the coating film, thus forming an organic thin film (hole injection layer) having a thickness of 80 nm. Thereafter, the same procedure as Example 4 was used to form a hole transport layer and an Al electrode on top of the hole injection layer, and then conduct an encapsulation treatment to obtain the organic HOD (4B).

### 2. Evaluation of Organic HODs

When a voltage was applied to the organic HODs obtained in Examples 1 to 4 and Comparative Examples 1 to 4, current flow was observed in each case, confirming that the organic HOD had hole injection functionality. For each organic HOD, the drive voltage at a current density of 300 mA/cm was measured. The measurement results are shown in Table 1.

**[Table 1]**

| | Drive voltage (at current density of 300 mA/cm) |
|---|---|
| Example 1 Organic HOD (1A) | 2.1 V |
| Comparative Example 1 Organic HOD (1B) | 2.5 V |
| Example 2 Organic HOD (2A) | 1.7 V |
| Comparative Example 2 Organic HOD (2B) | 1.9 V |
| Example 3 Organic HOD (3A) | 2.0 V |
| Comparative Example 3 Organic HOD (3B) | 2.2 V |
| Example 4 Organic HOD (4A) | 2.4 V |
| Comparative Example 4 Organic HOD (4B) | 2.8 V |

From the results shown in Table 1, it is evident that compared with the organic HODs (1B to 4B) of Comparative Examples 1 to 4 in which the heating of the coating films was conducted in an open atmosphere, the organic HODs (1A to 4A) of Examples 1 to 4 in which the heating of the coating films was conducted under an inert gas (nitrogen gas) atmosphere were able to be driven at a lower voltage. Accordingly, it is evident that in those cases where, as in Examples 1 to 4, the heating performed following coating film formation is conducted under an inert gas (nitrogen gas) atmosphere, deterioration in the performance of the organic thin film during film formation was able to be suppressed. More specifically, it is evident, based on a comparison of Example 1 and Example 4, that Example 1 exhibited a lower drive voltage, indicating that shortening the heating time under the inert gas atmosphere facilitated better suppression of any deterioration in the performance of the organic thin film. Further, based on a comparison of Example 1 with Examples 2 and 3, it is evident that when the proportion of polymerizable functional groups in the charge transport polymer is reduced, the suppression effect on any deterioration in the performance of the organic thin film as a result of the heating under an inert gas atmosphere can be more easily enhanced.

### <Production and Evaluation of Organic EL Elements>

The following description relates to the production of organic EL elements that includes an organic thin film formation step, and the evaluation of the characteristics of those organic EL elements.

### 1. Production of Organic EL Elements

### (Example 5)

In an open atmosphere, 51 µL of a solution prepared by mixing the polymerization initiator 1 shown above (5.0 mg) and toluene (2.5 mL) was added to and mixed with a solution containing the hole transport polymer 1 (10.0 mg) mixed with toluene (516 µL), thus preparing an ink composition 1. Further, the hole transport polymer 1 (10.0 mg) was mixed with toluene (2,301 µL) to prepare an ink composition 2.

The ink composition 1 was spin-coated at 3,000 min⁻¹ in an open atmosphere (25°C) onto a glass substrate on which ITO had been patterned with a width of 1.6 mm, thus forming a coating film. Subsequently, the glass substrate with the coating film was placed in a nitrogen atmosphere and heated on a hot plate at 200°C for 30 minutes to cure the coating film, thus forming an organic thin film (hole injection layer) having a thickness of 80 nm.

Subsequently, the ink composition 2 was spin-coated at 3,000 min⁻¹ in an open atmosphere (25°C) onto the top of the above hole injection layer to form a coating film. The glass substrate with the coating film was then placed in a nitrogen atmosphere and heated on a hot plate at 230°C for 30 minutes to cure the coating film, thus forming an organic thin film (hole transport layer) having a thickness of 20 nm.

The glass substrate having an ITO / hole injection layer / hole transport layer structure obtained in this manner was transferred to a vacuum deposition apparatus, and layers of CBP:Ir(ppy)₃ (94:6, 30 nm), BAlq (10 nm), Alq₃ (30 nm), LiF (0.8 nm) and Al (100 nm) were deposited in that order using deposition methods on top of the hole transport layer, and an encapsulation treatment was then performed to complete production of an organic EL element (1A).

### (Comparative Example 5)

With the exception of conducting the curing of the coating film used for forming the hole injection layer in an open atmosphere, an organic EL element (1B) was produced using the same production method as that described for the organic EL element (1A) of Example 5. In other words, first, in the same manner as described for Example 5, the ink composition 1 was spin-coated at 3,000 min⁻¹ in an open atmosphere (25°C) onto a glass substrate on which ITO had been patterned with a width of 1.6 mm, thus forming a coating film. Subsequently, the glass substrate with the coating film was heated on a hot plate at 200°C for 30 minutes in an open atmosphere to cure the coating film, thus forming an organic thin film (hole injection layer) having a thickness of 20 nm. Thereafter, the same procedure as Example 5 was used to deposit the various layers on top of the hole injection layer and then conduct an encapsulation treatment to obtain the organic EL element (1B).

### (Example 6)

In an open atmosphere, 51 µL of a solution prepared by mixing the polymerization initiator 1 shown above (5.0 mg) and toluene (2.5 mL) was added to and mixed with a solution containing the hole transport polymer 2 (10.0 mg) mixed with toluene (516 µL), thus preparing an ink composition 3. Further, the hole transport polymer 2 (10.0 mg) was mixed with toluene (2,301 µL) to prepare an ink composition 4.

The ink composition 3 was spin-coated at 3,000 min⁻¹ in an open atmosphere (25°C) onto a glass substrate on which ITO had been patterned with a width of 1.6 mm, thus forming a coating film. Subsequently, the glass substrate with the coating film was placed in a nitrogen atmosphere and heated on a hot plate at 200°C for 30 minutes to cure the coating film, thus forming an organic thin film (hole injection layer) having a thickness of 80 nm.

Subsequently, the ink composition 4 was spin-coated at 3,000 min⁻¹ in an open atmosphere (25°C) onto the top of the above hole injection layer to form a coating film. The glass substrate with the coating film was then placed in a nitrogen atmosphere and heated on a hot plate at 230°C for 30 minutes to cure the coating film, thus forming an organic thin film (hole transport layer) having a thickness of 20 nm.

The glass substrate having an ITO / hole injection layer / hole transport layer structure obtained in this manner was transferred to a vacuum deposition apparatus, and layers of CBP:Ir(ppy)₃ (94:6, 30 nm), BAlq (10 nm), Alq₃ (30 nm), LiF (0.8 nm) and Al (100 nm) were deposited in that order using deposition methods on top of the hole transport layer, and an encapsulation treatment was then performed to complete production of an organic EL element (2A).

### (Comparative Example 6)

With the exception of conducting the curing of the coating film used for forming the hole injection layer in an open atmosphere, an organic EL element (2B) was produced using the same production method as that described for the organic EL element (2A) of Example 6. In other words, first, in the same manner as described for Example 6, the ink composition 3 was spin-coated at 3,000 min⁻¹ in an open atmosphere (25°C) onto a glass substrate on which ITO had been patterned with a width of 1.6 mm, thus forming a coating film. Subsequently, the glass substrate with the coating film was heated on a hot plate at 200°C for 30 minutes in an open atmosphere to cure the coating film, thus forming an organic thin film (hole injection layer) having a thickness of 20 nm. Thereafter, the same procedure as Example 6 was used to deposit the various layers on top of the hole injection layer and then conduct an encapsulation treatment to obtain the organic EL element (2B).

### (Example 7)

In an open atmosphere, 51 µL of a solution prepared by mixing the polymerization initiator 1 shown above (5.0 mg) and toluene (2.5 mL) was added to and mixed with a solution containing the hole transport polymer 3 (10.0 mg) mixed with toluene (516 µL), thus preparing an ink composition 5. Further, the hole transport polymer 3 (10.0 mg) was mixed with toluene (2,301 µL) to prepare an ink composition 6.

The ink composition 5 was spin-coated at 3,000 min⁻¹ in an open atmosphere (25°C) onto a glass substrate on which ITO had been patterned with a width of 1.6 mm, thus forming a coating film. Subsequently, the glass substrate with the coating film was placed in a nitrogen atmosphere and heated on a hot plate at 200°C for 30 minutes to cure the coating film, thus forming an organic thin film (hole injection layer) having a thickness of 80 nm.

Subsequently, the ink composition 6 was spin-coated at 3,000 min⁻¹ in an open atmosphere (25°C) onto the top of the above hole injection layer to form a coating film. The glass substrate with the coating film was then placed in a nitrogen atmosphere and heated on a hot plate at 230°C for 30 minutes to cure the coating film, thus forming an organic thin film (hole transport layer) having a thickness of 20 nm.

The glass substrate having an ITO / hole injection layer / hole transport layer structure obtained in this manner was transferred to a vacuum deposition apparatus, and layers of CBP:Ir(ppy)₃ (94:6, 30 nm), BAlq (10 nm), Alq₃ (30 nm), LiF (0.8 nm) and Al (100 nm) were deposited in that order using deposition methods on top of the hole transport layer, and an encapsulation treatment was then performed to complete production of an organic EL element (3A).

### (Comparative Example 7)

With the exception of conducting the curing of the coating film used for forming the hole injection layer in an open atmosphere, an organic EL element (3B) was produced using the same production method as that described for the organic EL element (3A) of Example 7. In other words, first, in the same manner as described for Example 7, the ink composition 5 was spin-coated at 3,000 min⁻¹ in an open atmosphere (25°C) onto a glass substrate on which ITO had been patterned with a width of 1.6 mm, thus forming a coating film. Subsequently, the glass substrate with the coating film was heated on a hot plate at 200°C for 30 minutes in an open atmosphere to cure the coating film, thus forming an organic thin film (hole injection layer) having a thickness of 20 nm. Thereafter, the same procedure as Example 7 was used to deposit the various layers on top of the hole injection layer and then conduct an encapsulation treatment to obtain the organic EL element (3B).

### (Example 8)

In an open atmosphere, 51 µL of a solution prepared by mixing the polymerization initiator 1 shown above (5.0 mg) and toluene (2.5 mL) was added to and mixed with a solution containing the hole transport polymer 1 (10.0 mg) mixed with toluene (516 µL), thus preparing an ink composition 1. Further, the hole transport polymer 1 (10.0 mg) was mixed with toluene (2,301 µL) to prepare an ink composition 2.

The ink composition 1 was spin-coated at 3,000 min⁻¹ in an open atmosphere (25°C) onto a glass substrate on which ITO had been patterned with a width of 1.6 mm, thus forming a coating film. Subsequently, the glass substrate with the coating film was placed in a nitrogen atmosphere and heated on a hot plate at 200°C for 60 minutes to cure the coating film, thus forming an organic thin film (hole injection layer) having a thickness of 80 nm.

Subsequently, the ink composition 2 was spin-coated at 3,000 min⁻¹ in an open atmosphere (25°C) onto the top of the above hole injection layer to form a coating film. The glass substrate with the coating film was then placed in a nitrogen atmosphere and heated on a hot plate at 230°C for 30 minutes to cure the coating film, thus forming an organic thin film (hole transport layer) having a thickness of 20 nm.

The glass substrate having an ITO / hole injection layer / hole transport layer structure obtained in this manner was transferred to a vacuum deposition apparatus, and layers of CBP:Ir(ppy)₃ (94:6, 30 nm), BAlq (10 nm), Alq₃ (30 nm), LiF (0.8 nm) and Al (100 nm) were deposited in that order using deposition methods on top of the hole transport layer, and an encapsulation treatment was then performed to complete production of an organic EL element (4A).

### (Comparative Example 8)

With the exception of conducting the curing of the coating film used for forming the hole injection layer in an open atmosphere, an organic EL element (4B) was produced using the same production method as that described for the organic EL element (4A) of Example 8. In other words, first, in the same manner as described for Example 8, the ink composition 1 was spin-coated at 3,000 min⁻¹ in an open atmosphere (25°C) onto a glass substrate on which ITO had been patterned with a width of 1.6 mm, thus forming a coating film. Subsequently, the glass substrate with the coating film was heated on a hot plate at 200°C for 30 minutes in an open atmosphere to cure the coating film, thus forming an organic thin film (hole injection layer) having a thickness of 20 nm. Thereafter, the same procedure as Example 8 was used to deposit the various layers on top of the hole injection layer and then conduct an encapsulation treatment to obtain the organic EL element (4B).

### 2. Evaluation of Organic EL Elements

When a voltage was applied to each of the organic EL elements obtained in Examples 5 to 8 and Comparative Examples 5 to 8, a green light emission was confirmed in each case. For each organic EL element, the drive voltage and emission efficiency at an emission luminance of 1,000 cd/m², and the emission lifespan (luminance half-life) when the initial luminance was 5,000 cd/m² were measured. The measurement results are shown in Table 2.

**[Table 2]**

| | Drive voltage (V) | Emission efficiency (cd/A) | Emission lifespan (h) |
|---|---|---|---|
| Example 5 Organic EL element (1A) | 7.2 | 30.0 | 303 |
| Comparative Example 5 Organic EL element (1B) | 8.2 | 28.0 | 250 |
| Example 6 Organic EL element (2A) | 6.8 | 31.0 | 307 |
| Comparative Example 6 Organic EL element (2B) | 7.2 | 31.0 | 280 |
| Example 7 Organic EL element (3A) | 7.0 | 30.5 | 300 |
| Example 7 Organic EL element (3A) | 7.5 | 29.9 | 276 |
| Example 8 Organic EL element (4A) | 7.6 | 28.0 | 200 |
| Comparative Example 8 Organic EL element (4B) | 8.8 | 25.0 | 159 |

From the results shown in Table 2 it is evident that compared with the organic EL elements (1B to 4B) of the comparative examples in which the heating of the coating film for forming the hole injection layer was conducted in an open atmosphere, the organic EL elements (1A to 4A) of the examples in which the heating of the coating film was conducted under an inert gas (nitrogen gas) atmosphere exhibited lower drive voltages, higher emission efficiency, and longer emission lifespans. Based on these results, it is evident that by heating the organic thin film under an inert gas atmosphere, an organic thin film having superior characteristics can be formed. Accordingly, it is evident that by using an organic thin film produce using the production method of the present invention, the characteristics of organic EL elements can be improved.

### <Oxygen Concentration Distribution of Organic Thin Films (Laminates)>

### 1. Production of Laminates

### (Example 9)

In an open atmosphere, 51 µL of a solution prepared by mixing the polymerization initiator 1 shown above (5.0 mg) and toluene (2.5 mL) was added to and mixed with a solution containing the hole transport polymer 1 (10.0 mg) mixed with toluene (516 µL), thus preparing an ink composition 1. Further, the hole transport polymer 1 (10.0 mg) was mixed with toluene (2,301 µL) to prepare an ink composition 2.

The ink composition 1 was spin-coated at 3,000 min⁻¹ in an open atmosphere (25°C) onto a quartz glass substrate on which a film of ITO had been formed (hereafter also referred to as an ITO substrate), thus forming a coating film. Subsequently, the quartz glass substrate with the coating film was placed in a nitrogen atmosphere and heated on a hot plate at 200°C for 30 minutes to cure the coating film, thus forming an organic thin film (hole injection layer) having a thickness of 80 µm.

Subsequently, the ink composition 2 was spin-coated at 3,000 min⁻¹ in an open atmosphere (25°C) onto the top of the above hole injection layer to form a coating film. The coating film was then placed in a nitrogen atmosphere and heated on a hot plate at 230°C for 30 minutes to cure the coating film, thus forming an organic thin film (hole transport layer) having a thickness of 20 nm. In this manner, a laminate having a hole injection layer and a hole transport layer on top of an ITO substrate was produced, and this laminate was used as a measurement sample (1A).

### (Comparative Example 9)

With the exception of conducting the heating of the coating film used for forming the hole injection layer in an open atmosphere, a measurement sample (1B) was produced using exactly the same production method as that described for producing the measurement sample (1A) in Example 9. In other words, first, the ink composition 1 prepared in the same manner as described in Example 9 was spin-coated at 3,000 min⁻¹ in an open atmosphere (25°C) onto an ITO substrate, thus forming a coating film. Subsequently, the ITO substrate with the coating film was heated on a hot plate at 200°C for 30 minutes in an open atmosphere to cure the coating film, thus forming an organic thin film (hole injection layer) having a thickness of 80 µm.

Subsequently, the ink composition 2 prepared in the same manner as described in Example 9 was spin-coated at 3,000 min⁻¹ in an open atmosphere (25°C) onto the hole injection layer, thus forming a coating film. The coating film was then cured in a nitrogen atmosphere by heating on a hot plate at 200°C for 30 minutes, thus forming an organic thin film (hole transport layer) having a thickness of 20 µ. In this manner, a laminate having a hole injection layer and a hole transport layer on top of an ITO substrate was produced, and this laminate was used as a measurement sample (1B).

### 2. Evaluation of Dispersion in Oxygen Atom Distribution

For each of the measurement samples produced in Example 9 and Comparative Example 9, the procedure described below was used to measure the oxygen ion intensity (count) through the depth direction (vertical direction) of the laminate including the interface between the two organic thin films, using gas cluster ion beam time-of-flight secondary ion mass spectrometry (GCIB-TOF-SIMS). The dispersion in the oxygen atom distribution was then evaluated based on the measured values.

### (1) Measurement

An Ar cluster was irradiated as a gas cluster ion beam onto the surface of each measurement sample (from the side of the hole transport layer), and a time-of-flight secondary ion mass spectrometer was used to measure the oxygen ion intensity (count) through the depth direction of the laminate. The measurement conditions were as follows.

### (Measurement Conditions)

Measurement apparatus: TOF.SIMS 5-200P manufactured by Hitachi Maxell Science Co., Ltd.
Primary ion source: Bi
Primary accelerating voltage: 25 kV

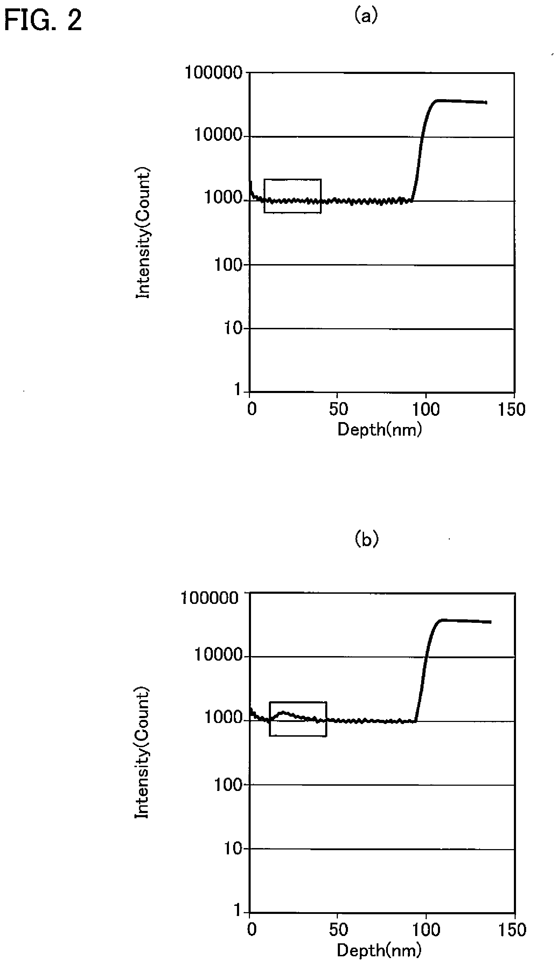

The oxygen atom distribution profiles measured through the depth direction by GCIB-TOF-SIMS in this manner are shown in FIG. 2. FIG. 2(a) represents the measurement results for Example 9, and FIG. 2(b) represents the measurement results for Comparative Example 9. In each of the profiles, the vertical axis of the profile indicates the oxygen ion intensity (count).

### (2) Dispersion in Oxygen Atom Distribution

Based on the average value A and the standard deviation B of the oxygen ion intensity values in each profile read at 1 nm intervals in a range from 10 to 40 nm in the depth direction, the percentage (%) of dispersion (B/A) in the oxygen atom distribution was determined. The results are shown in Table 3.

**[Table 3]**

| | Average value A | Standard deviation B | Dispersion (%) |
|---|---|---|---|
| Example 9 | 1015 | 32.5 | 3.2 |
| Comparative Example 9 | 1173 | 105 | 9.0 |

As is evident from Table 3, whereas the dispersion in the amount of oxygen atoms was large in Comparative Example 9, the dispersion in the oxygen distribution was clearly less in Example 9. Based on this result, it is evident that when forming an organic thin film adjacent to an ITO substrate using a wet process, by conducting the heating of the coating film within an inert gas atmosphere, surface oxidation of the organic thin film can be effectively suppressed. As is evident from a comparison of the examples and comparative examples described above, in organic HODs and organic EL elements, differences in the organic thin film production methods result in clear actual differences in the performance of the organic thin films. Accordingly, it is evident that when forming an organic thin film using a wet process, by conducting the heating of the coating film in an inert gas atmosphere, any deterioration in the performance of the organic thin film can be suppressed, and by constructing an organic EL element using such an organic thin film, the element characteristics such as the drive voltage can be improved.

### DESCRIPTION OF THE REFERENCE SIGNS

- 1:: Light-emitting layer
- 2:: Anode
- 3:: Hole injection layer
- 4:: Cathode
- 5:: Electron injection layer
- 6:: Hole transport layer
- 7:: Electron transport layer
- 8:: Substrate

## Claims

1. A method for producing an organic thin film comprising a step of forming a coating film by applying an organic electronic material comprising a charge transport compound, and a step of heating the coating film under an inert gas atmosphere to form an organic thin film.

2. The method for producing an organic thin film according to Claim 1, wherein the organic electronic material also comprises a solvent.

3. The method for producing an organic thin film according to Claim 1 or 2, wherein the charge transport compound has hole injection properties or hole transport properties.

4. The method for producing an organic thin film according to any one of Claims 1 to 3, wherein the charge transport compound contains at least one structure selected from the group consisting of aromatic amine structures, pyrrole structures, carbazole structures, thiophene structures, benzene structures, aniline structures, phenoxazine structures and fluorene structures.

5. The method for producing an organic thin film according to any one of Claims 1 to 4, wherein the charge transport compound has a structure that is branched in three or more directions.

6. The method for producing an organic thin film according to any one of Claims 1 to 5, wherein the charge transport compound has at least one polymerizable functional group.

7. The method for producing an organic thin film according to Claim 6, wherein the polymerizable functional group is at least one group selected from the group consisting of an oxetane group, epoxy group, vinyl group, acryloyl group, and methacryloyl group.

8. The method for producing an organic thin film according to any one of Claims 1 to 7, wherein the organic electronic material also comprises a polymerization initiator.

9. The method for producing an organic thin film according to Claim 8, wherein the polymerization initiator is an ionic compound.

10. The method for producing an organic thin film according to Claim 9, wherein the ionic compound is an onium salt.

11. An organic thin film produced using the method for producing an organic thin film according to any one of Claims 1 to 10.

12. A laminate having an organic thin film formed from an organic electronic material comprising a charge transport compound, and an upper layer provided on top of the organic thin film, wherein a dispersion in an oxygen atom distribution through a depth direction of the laminate including an interface between the organic thin film and the upper layer, calculated by irradiating a gas cluster ion beam onto the laminate from a side of the upper layer and measuring an oxygen ion intensity through the depth direction with a time-of-flight secondary ion mass spectrometer, is not more than 8.0%.

13. An organic electroluminescent element having the organic thin film according to Claim 11 or the laminate according to Claim 12.

14. The organic electroluminescent element according to Claim 13, also having a flexible substrate.

15. The organic electroluminescent element according to Claim 13, also having a resin film substrate.

16. A display element comprising the organic electroluminescent element according to any one of Claims 13 to 15.

17. An illumination device comprising the organic electroluminescent element according to any one of Claims 13 to 15.

18. A display device comprising the illumination device according to Claim 17 and a liquid crystal element as a display unit.

19. A method for producing an organic electroluminescent element having at least an organic thin film and a light-emitting layer disposed in that order between an anode and a cathode, with the organic thin film disposed adjacent to the anode, wherein
the method has a step of forming the organic thin film on the anode using the method for producing an organic thin film according to any one of Claims 1 to 10, a step of forming the light-emitting layer, and a step of forming the cathode.
